# EUROPEAN PATENT APPLICATION

(11) **EP 4 850 844 A1**
(43) Date of publication of application: **09.12.2026**
(21) Application number: 26169135.6
(22) Date of filing: 30.03.2026
(51) Int. Cl.: B23K 26/04

(54) **METHOD FOR FABRICATING DISPLAY DEVICE, DISPLAY DEVICE, AND ELECTRONIC DEVICE**

(30) Priority: 12.05.2025 KR 20250061358
(71) Applicant: Samsung Display Co., Ltd., Yongin-si, Gyeonggi-do 17113 (KR)
(72) Inventor: KIM, Jeong Ho, 17113 Yongin-si, Gyeonggi-do (KR); KIM, Hyung-Sik, 17113 Yongin-si, Gyeonggi-do (KR); RYU, Je Yun, 17113 Yongin-si, Gyeonggi-do (KR); MISHCHIK, Konstantin, 17113 Yongin-si, Gyeonggi-do (KR); LEE, Ki Sang, 17113 Yongin-si, Gyeonggi-do (KR); KIM, Jeong Su, 17113 Yongin-si, Gyeonggi-do (KR); JOO, Chu Jong, 17113 Yongin-si, Gyeonggi-do (KR); HWANG, Se Yeon, 17113 Yongin-si, Gyeonggi-do (KR)
(74) Representative: Gulde & Partner

(57) **Abstract**

Provided are a method for fabricating display device, a display device, and an electronic device, the method including forming display cells on a first surface of a mother substrate, using a first inspection device to check alignment of a laser beam, which includes a processing laser beam including spot beams on a curve in a cross-section cut in a first direction that is a thickness direction of the mother substrate, and a first alignment key including key spot beams at a same height in the first direction, by focusing on the key spot beams, irradiating the laser beam to form first sketch lines along edges of the display cells, checking the first sketch lines using a second inspection device, reducing a thickness of the mother substrate by spraying an etchant onto a second surface of the mother substrate, and cutting the mother substrate along the first sketch lines.

## Description

### BACKGROUND

### 1. Field

The present disclosure relates to a method for fabricating a display device, to a display device, and to an electronic device.

### 2. Description of the Related Art

As the information-oriented society evolves, various demands for display devices are ever increasing. A display device may be a flat-panel display device such as a liquid-crystal display device, a field emission display device, and a light-emitting display device.

A display device includes a display area where images are displayed, and a non-display area around the display area, for example. Recently, the width of the non-display area is ever decreasing in order for viewers to get more immersed in the contents displayed on the display area and to increase the aesthetics of the display device.

Incidentally, in the process of fabricating a display device, the display device may be formed by cutting a mother substrate along a plurality of display cells formed thereon.

### SUMMARY

The invention is defined by the appended claims. The description that follows is subject to this limitation. Any disclosure lying outside the scope of said claims is only intended for illustrative as well as comparative purposes.

Aspects of the present invention provide a method for fabricating a display device that can improve precision of a process of cutting a mother substrate, a display device, and an electronic device.

It should be noted that aspects of the present disclosure are not limited to the above, and that other aspects of the present disclosure will be apparent to those skilled in the art from the following descriptions.

According to an aspect of the present disclosure, there is provided a method for fabricating a display device, the method including forming display cells on a first surface of a mother substrate, using a first inspection device to check alignment of a laser beam, which includes a processing laser beam including spot beams arranged on a curve in a cross-section cut in a first direction that is a thickness direction of the mother substrate, and a first alignment key including key spot beams at a same height in the first direction, by focusing on the key spot beams, irradiating the laser beam to form first sketch lines along edges of the display cells, checking the first sketch lines using a second inspection device, reducing a thickness of the mother substrate by spraying an etchant onto a second surface opposite to the first surface of the mother substrate, and cutting the mother substrate along the first sketch lines.

The key spot beams may be in a first plane substantially perpendicular to the first direction.

The key spot beams may include a first key spot beam, a second key spot beam aligned with the first key spot beam in a second direction substantially perpendicular to the first direction, and a third key spot beam aligned with the second key spot beam in a third direction substantially perpendicular to the first direction and in a same plane as the second direction.

The laser beam may include a first area where the spot beams are arranged, and a second area where the key spot beams are arranged and having a volume that is larger than a volume of the first area.

The second area may be above the first area.

The second area might not overlap the first area in a horizontal direction substantially perpendicular to the first direction.

The laser beam may further include a second alignment key including a monitoring spot beam overlapping the processing laser beam in a horizontal direction substantially perpendicular to the first direction.

One of the first sketch lines may include spots formed by the spot beams, and a monitoring spot formed by the monitoring spot beam.

The monitoring spot may be on a dummy between the display cells.

The monitoring spot may be on a side of the processing laser beam that is adjacent to the display cells, and may be removed by the etchant.

The method may further include using the second inspection device to check deviations of the laser beam in the first direction based on a distance between the monitoring spot and the first surface in the first direction or a distance between the monitoring spot and the second surface in the first direction.

The first alignment key may be above the processing laser beam in the first direction.

The first alignment key may overlap the processing laser beam in a horizontal direction substantially perpendicular to the first direction, wherein the key spot beams include a first monitoring key spot beam on a straight line with a first spot beam among the spot beams in the first direction, a second monitoring key spot beam on a straight line with a second spot beam among the spot beams in a second direction crossing the first direction, and a third monitoring key spot beam on a straight line with a third spot beam among the spot beams in a third direction crossing the first direction and the second direction.

The method may further include forming second sketch lines for forming a through hole in the display cells by irradiating the laser beam.

The method may further include inspecting the second sketch lines using the second inspection device.

The method may further include reducing a thickness of the mother substrate by spraying the etchant onto the second surface of the mother substrate, and cutting the mother substrate along the second sketch lines.

The method may further include separating the display cells from the mother substrate.

According to an aspect of the present invention, there is provided a display device including a glass substrate including a first surface, a second surface facing the first surface, and a side surface between the first surface and the second surface, having a curved shape, and including a first layer adjacent to the second surface and including processing marks, and a second layer adjacent to the first surface and including processing marks, an average value of sizes of the processing marks of the first layer being less than an average value of sizes of the processing marks of the second layer, an outermost structure on the first surface and adjacent to an edge of the side surface, and a display area including emission areas further from the edge than the outermost structure on the first surface.

Deviations of the processing marks of the first layer and deviations of the processing marks of the second layer may be equal to or less than about 25 µm.

According to an aspect of the present invention, there is provided an electronic device including a display device for displaying images fabricated by forming display cells on a first surface of a mother substrate, using a first inspection device to check alignment of a laser beam, which includes a processing laser beam including spot beams arranged on a curve in a cross-section cut in a first direction that is a thickness direction of the mother substrate, and a first alignment key including key spot beams at a same height in the first direction, by focusing on the key spot beams, irradiating the laser beam to form first sketch lines along edges of the display cells, checking the first sketch lines using a second inspection device, reducing a thickness of the mother substrate by spraying an etchant onto a second surface opposite to the first surface of the mother substrate, and cutting the mother substrate along the first sketch lines, a processor for providing an image driving signal to the display device, and a power supply for supplying power to the display device and the processor.

According to one or more embodiments of the present disclosure, precision of a process of cutting a mother substrate can be improved.

It should be noted that aspects of the present disclosure are not limited to those described above and other aspects of the present disclosure will be apparent to those skilled in the art from the following descriptions.

### BRIEF DESCRIPTION OF THE DRAWINGS

The above and other aspects of the present disclosure will become more apparent by describing in detail embodiments thereof with reference to the attached drawings, in which:
FIG. 1 is a perspective view showing a display device according to one or more embodiments of the present disclosure.
FIG. 2 is a plan view showing a display panel and driver ICs according to one or more embodiments.
FIG. 3 is a cross-sectional view taken along line X1 - X1' in FIG. 1.
FIG. 4 is a cross-sectional view showing the display device of FIG. 3 when it is bent.
FIG. 5 is a cross-sectional view showing an example of a display area of a display device according to one or more embodiments of the present disclosure.
FIG. 6 is an enlarged view of area A of FIG. 2.
FIG. 7 is a cross-sectional view taken along the line X2 - X2' of FIG. 6.
FIG. 8 is an enlarged view of area C of FIG. 7.
FIG. 9 is an enlarged view of area B of FIG. 2.
FIG. 10 is a cross-sectional view, taken along the line X3 - X3' in FIG. 9.
FIG. 11 is an enlarged view of area D of FIG. 10.
FIG. 12 is a side view showing an example of a side surface of an edge of a display panel and a side surface of an edge of a through hole according to one or more embodiments.
FIG. 13 is a flowchart for illustrating a method for fabricating a display device according to one or more embodiments of the present disclosure.
FIG. 14 is a perspective view for illustrating operation S110 of FIG. 13.
FIG. 15 is a cross-sectional view, taken along the line X4 - X4' in FIG. 14.
FIG. 16 is a perspective view for illustrating operation S120 of FIG. 13.
FIG. 17 is a view schematically showing shapes of a laser beam and a first alignment key in the xz plane according to one or more embodiments.
FIG. 18 is a view schematically showing a shape of a first alignment key in the xy plane according to one or more embodiments.
FIGS. 19 and 20 are views for illustrating examples where first alignment keys are not aligned.
FIG. 21 is a perspective view showing operation S130 of FIG. 13.
FIG. 22 is a cross-sectional view, taken along the line X4 - X4' in FIG. 21.
FIG. 23 is a cross-sectional view taken along the line X5 - X5' in FIG. 21.
FIG. 24 is a perspective view for illustrating operation S140 of FIG. 13.
FIG. 25 is a view schematically showing shapes of a laser beam and a second alignment key in the xz plane according to one or more embodiments.
FIG. 26 is an image showing the shapes of a sketch line and a monitoring spot according to one or more embodiments.
FIG. 27 is an image showing a cross-section of a mother substrate captured by a second inspection device according to one or more embodiments.
FIG. 28 is a perspective view for illustrating operation S150 of FIG. 13.
FIG. 29 is a cross-sectional view showing an example, taken along the line X4 - X4' of FIG. 28.
FIG. 30 is a cross-sectional view taken along the line X5 - X5' in FIG. 28.
FIG. 31 is a cross-sectional view showing another example, taken along the line X5 - X5' of FIG. 28.
FIG. 32 is a perspective view for illustrating operation S160 of FIG. 13.
FIG. 33 is a cross-sectional view taken along the line X4 - X4' in FIG. 21.
FIG. 34 is a cross-sectional view taken along the line X5 - X5' of FIG. 21.
FIG. 35 is a view schematically showing the shapes of a laser beam and first and second alignment keys according to one or more other embodiments.
FIG. 36 is a block diagram of an electronic device according to one or more embodiments of the present disclosure.
FIG. 37 is a view showing electronic devices according to a variety of embodiments of the present disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, if a first part is described as being arranged "on" a second part, this indicates that the first part is arranged at an upper side or a lower side of the second part without the limitation to the upper side thereof on the basis of the gravity direction.

Further, the phrase "in a plan view" means if an object portion is viewed from above, and the phrase "in a schematic cross-sectional view" means if a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that if an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, if a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, if a portion of a layer, a film, an area, a plate, or the like is formed on another portion, a forming direction is not limited to an upper direction but includes forming the portion on a side surface or in a lower direction. On the contrary, if a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that if an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer, or section described below could be termed a second element, component, region, layer, or section, without departing from the spirit and scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. The terms or words used in the present specification and claims are not to be limitedly interpreted as general or dictionary meanings and should be interpreted as meanings and concepts that are consistent with aspects of the present disclosure on the basis that an inventor can be their own lexicographer to appropriately define concepts of terms to describe the embodiments in the best way.

As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

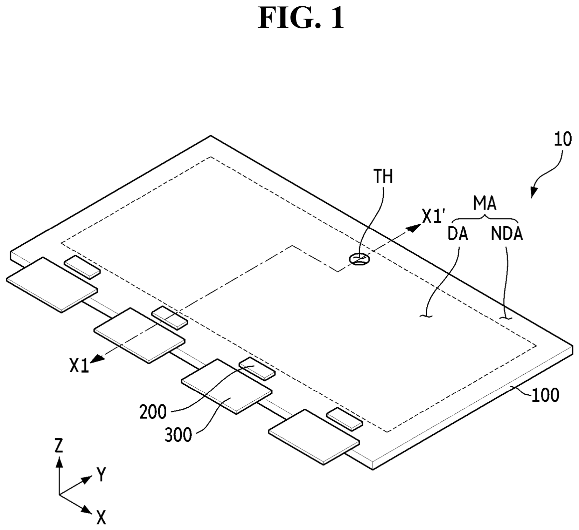

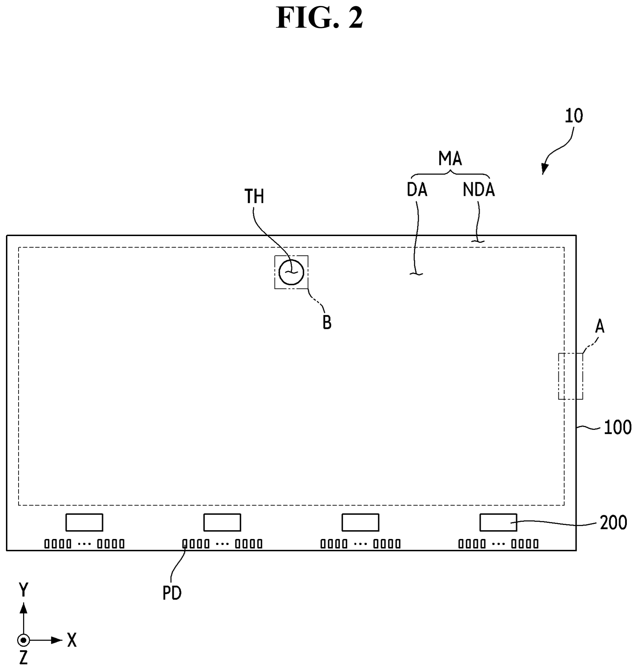

FIG. 1 is a perspective view showing a display device according to one or more embodiments of the present disclosure. FIG. 2 is a plan view showing a display panel and driver ICs according to one or more embodiments.

Referring to FIGS. 1 and 2, a display device 10 according to one or more embodiments of the present disclosure is for displaying moving images or still images. The display device 1 may be used as the display screen of portable electronic devices, such as a mobile phone, a smart phone, a tablet PC, a smart watch, a watch phone, a mobile communications terminal, an electronic notebook, an electronic book, a portable multimedia player (PMP), a navigation device, and a ultra mobile PC (UMPC), as well as the display screen of various products, such as a television, a notebook, a monitor, a billboard and the Internet of Things device.

According to one or more embodiments of the present disclosure, the display device 10 may be a light-emitting display device, such as an organic light-emitting display device using organic light-emitting diodes, a quantum-dot light-emitting display device including quantum-dot light-emitting layer, an inorganic light-emitting display device including an inorganic semiconductor, and a micro-LED display device using micro or nano light-emitting diodes (micro LEDs or nano LEDs). In the following description, an organic light-emitting display device is described as an example of the display device 10. It is, however, to be understood that the present disclosure is not limited thereto.

The display device 10 may include a display panel 100, a driver integrated circuits (ICs) 200, and circuit boards 300.

The display panel 100 may be formed in a rectangular plane having longer sides in a first direction (x-axis direction) and shorter sides in a second direction (y-axis direction) crossing the first direction (x-axis direction). Each of the corners where the longer side in the first direction (x-axis direction) meets the shorter side in the second direction (y-axis direction) may be formed at a right angle or may be rounded with a curvature. The shape of the display panel 100 when viewed from the top (e.g., in plan view) is not limited to a quadrangular shape, but may be formed in a different polygonal shape, a circular shape, or an elliptical shape.

In the drawings, the first direction (x-axis direction) and the second direction (y-axis direction) cross each other as the horizontal directions. For example, the first direction (x-axis direction) and the second direction (y-axis direction) may be orthogonal to each other. In addition, a third direction (z-axis direction) may cross the first direction (x-axis direction) and the second direction (y-axis direction), and may be, for example, a vertical direction orthogonal to them. Unless stated otherwise herein, the side indicated by the arrow of each of the first to third directions (x-axis direction, y-axis direction and z-axis direction) may be referred to as a first side, while the opposite side may be referred to as a second side. As used herein, the terms "on," "upper side," "above," "top" and "upper surface" refer to the side indicated by the arrow of the third direction (z-axis direction) as shown in the drawings. The terms "under," "lower side," "below," "bottom" and "lower surface" refer to the opposite side indicated by the arrow of the third direction (z-axis direction) as shown in the drawings.

The display panel 100 may be formed flat, but the present disclosure is not limited thereto. For example, the display panel 100 may be formed at left and right ends, and may include a curved portion having a constant curvature or a varying curvature. In addition, the display panel 100 may be flexible so that it can be curved, bent, folded or rolled.

The display panel 100 may include a display area DA where images are displayed, and a non-display area NDA located around the display area DA. The display area DA and the non-display area NDA may form a main area MA.

The display area DA may occupy most of the area of the display panel 100. The display area DA may be located at the center of display panel 100. In the display area DA, pixels each including a plurality of emission areas may be arranged to display images.

The non-display area NDA may be located adjacent to the display area DA. The non-display area NDA may be located on the outer side of the display area DA. The non-display area NDA may surround the display area DA (e.g., surround in plan view). The non-display area NDA may be the border region of the display panel 100.

In the non-display area NDA, display pads DP may be arranged to be connected to the circuit boards 300. The display pads PD may be arranged at one edge of the display panel 100. For example, the display pads PD may be arranged at the lower edge of the display panel 100.

The driver integrated circuits (ICs) 200 may generate data voltages, supply voltages, scan timing signals, etc. The driver ICs 200 may output data voltages, supply voltages, scan timing signals, etc.

The driver ICs 200 may be located between the display pads PD and the display area DA in the non-display area NDA. The driver ICs 200 may be attached to the non-display area NDA of the display panel 100 by a chip-on-glass (COG) technique. Alternatively, the driver ICs 200 may be attached to the circuit boards 300, respectively, by a chip-on-plastic (COP) technique.

The circuit boards 300 may be located on the display pads PD located at one edge of the display panel 100. The circuit boards 300 may be attached to the display pads PD using a conductive adhesive member, such as an anisotropic conductive film and an anisotropic conductive adhesive. Accordingly, the circuit boards 300 may be electrically connected to signal lines of the display panel 100. The circuit boards 300 may be flexible printed circuit boards, flexible films, such as chip-on-films.

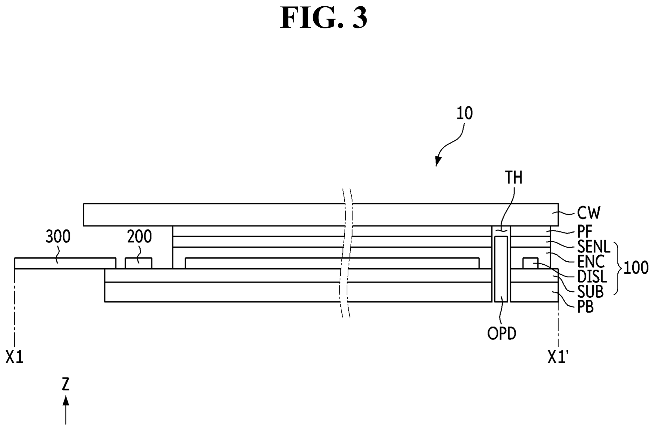

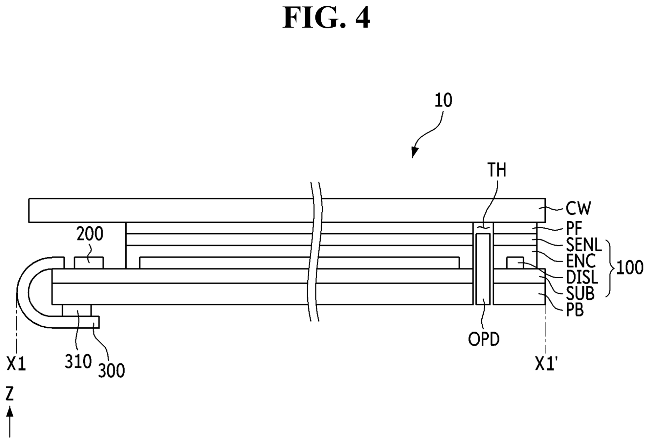

FIG. 3 is a cross-sectional view taken along the line X1 - X1' in FIG. 1. FIG. 4 is a cross-sectional view showing the display device of FIG. 3 when it is bent.

Referring to FIGS. 3 and 4 in conjunction with FIGS. 1 and 2, the display device 10 may further include a display panel 100, a polarizing film PF, a cover window CW, a panel bottom cover PB, a driver IC 200, and a circuit board 300. The display panel 100 may include a substrate SUB, a display layer DISL, an encapsulation layer ENC, and a sensor electrode layer SENL.

The substrate SUB may have a rigid material. For example, the substrate SUB may be made of glass. The substrate SUB may be formed of ultra-thin glass (UTG) having a thickness of approximately 500 µm or less. For example, the thickness of the substrate SUB may be approximately 200 µm. In one or more other embodiments, the substrate SUB may include a first substrate made of a rigid material and a second substrate made of a polymer resin having a flexible material.

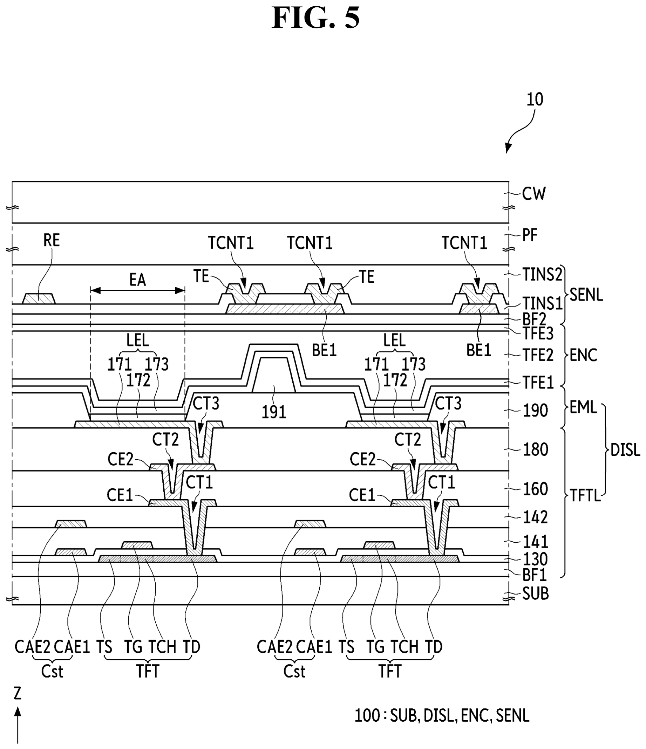

The display layer DISL may be located on a first surface of the substrate SUB. The display layer DISL may display images. The display layer DISL may include a thin-film transistor layer TFTL (see FIG. 5) in which thin-film transistors are formed, and an emission material layer EML (see FIG. 5) in which light-emitting elements that emit lights are arranged in the emission areas.

In the display area DA of the display layer DISL, scan lines, data lines, voltage lines, etc., may be located so that lights are emitted in the emission areas. In the non-display area NDA of the display layer DISL, a scan driver circuit FOR outputting scan signals to the scan lines, fan-out lines connecting the data lines with the driver ICs 200, etc., may be arranged.

The encapsulation layer ENC may encapsulate the emission material layer of the display layer DISL to reduce or prevent oxygen or moisture from permeating into the emission material layer of the display layer DISL. The encapsulation layer ENC may be located on the display layer DISL. The encapsulation layer ENC may be located on the upper and side surfaces of the display layer DISL. The encapsulation layer ENC may cover the display layer DISL.

The sensor electrode layer SENL may be located on the display layer DISL. The sensor electrode layer SENL may include sensor electrodes. The sensor electrode layer SENL can sense a user's touch using the sensor electrodes.

The polarizing film PF may be located on the sensor electrode layer SENL. The polarizing film PF may be located on the display panel 100 to reduce reflection of external light. The polarizing film PF may include a first base member, a linear polarizer, a retardation film, such as a λ/4 (quarter-wave) plate, and a second base member. The first base member, the retardation film, the linear polarizer and the second base member of the polarizing film PF may be sequentially stacked on the display panel 100.

The cover window CW may be located on the polarizing film PF. The cover window CW may be attached onto the polarizing film PF by a transparent adhesive member, such as an optically clear adhesive (OCA) film.

The panel bottom cover PB may be located on a second surface of the substrate SUB of the display panel 100. The second surface of the substrate SUB may be opposite to the first surface. The panel bottom cover PB may be attached to the second surface of the substrate SUB of the display panel 100 by an adhesive member. The adhesive member may be a pressure-sensitive adhesive (PSA).

The panel bottom cover PB may include at least one of: a light-blocking member for absorbing light incident from outside, a buffer member for absorbing external impact, or a heat-dissipating member for efficiently discharging heat from the display panel 100.

The driver IC 200 and the circuit board 300 may be bent such that they are located under the display panel 100, as shown in FIG. 4. The circuit board 300 may be attached to the lower surface of the panel bottom cover PB by an adhesive member 310. The adhesive member 310 may be a pressure-sensitive adhesive.

The display device 10 may further include a through hole TH and an optical device OPD placed in the through hole TH.

The through hole TH may allow light to pass through it, and may be a physical hole penetrating through the panel bottom cover PB and the polarizing film PF as well as the display panel 100. For example, the through hole TH may penetrate through the substrate SUB, the display layer DISL, the encapsulation layer ENC and the sensor electrode layer SENL of the display panel 100. It should be understood, however, that the present disclosure is not limited thereto. The through hole TH may penetrate through the panel bottom cover PB but may not penetrate through the display panel 100 or the polarizing film PF. The cover window CW may cover the through hole TH.

The optical device OPD may be spaced apart from the display panel 100, the panel bottom cover PB and the polarizing film PF. The optical device OPD may be an optical sensor that senses light incident through the through hole TH, such as a proximity sensor, an illuminance sensor, and a camera sensor.

FIG. 5 is a cross-sectional view showing an example of a display area of a display device according to one or more embodiments of the present disclosure.

Referring to FIG. 5, the display device 10 may include the display panel 100, the polarizing film PF, and the cover window CW.

The display panel 100 may be an organic light-emitting display panel including light-emitting elements LEL each including an organic emissive layer 172. The display panel 100 may include a substrate SUB, a display layer DISL, an encapsulation layer ENC, and a sensor electrode layer SENL. The display layer DISL may include a thin-film transistor layer TFTL including a plurality of thin-film transistors and an emission material layer EML including a plurality of light-emitting elements.

The substrate SUB may have a rigid material. For example, the substrate SUB may be made of glass. The substrate SUB may be formed of ultra-thin glass (UTG) having a thickness of approximately 500 µm or less. For example, the thickness of the substrate SUB may be approximately 200 µm. In one or more other embodiments, the substrate SUB may include a first substrate made of a rigid material and a second substrate made of a polymer resin having a flexible material.

The thin-film transistor layer TFTL may include a first buffer film BF1, a thin-film transistor TFT, a gate insulator 130, a first interlayer dielectric layer 141, a capacitor Cst, a second interlayer dielectric layer 142, a first data metal layer, a first organic layer 160, a second data metal layer, and a second organic layer 180.

The first buffer film BF1 may be located on the substrate SUB. The first buffer film BF1 may be formed of an inorganic material, such as a silicon nitride layer, a silicon oxynitride layer, a silicon oxide layer, a titanium oxide layer, and an aluminum oxide layer. Alternatively, the first buffer film BF1 may be made up of multiple layers in which two or more of a silicon nitride layer, a silicon oxynitride layer, a silicon oxide layer, a titanium oxide layer and an aluminum oxide layer are stacked on one another.

An active layer including a channel region TCH, a source region TS and a drain region TD of the thin-film transistor TFT may be located on the first buffer film BF1. The active layer may be made of polycrystalline silicon, monocrystalline, low-temperature polycrystalline silicon, amorphous silicon, or an oxide semiconductor. When the active layer includes polycrystalline silicon or an oxide semiconductor material, the source region TS and the drain region TD in the active layer may be conductive regions doped with ions or impurities to have conductivity.

The gate insulator 130 may be located on the active layer of the thin-film transistor TFT. The gate insulator 130 may include an inorganic layer, for example, a silicon nitride layer, a silicon oxynitride layer, a silicon oxide layer, a titanium oxide layer, or an aluminum oxide layer.

A first gate metal layer including a gate electrode TG of the thin-film transistor TFT, a first capacitor electrode CAE1 of a capacitor Cst, and scan lines may be located on the gate insulator 130. The gate electrode G of the thin-film transistor TFT may overlap the channel region TCH in the third direction (z-axis direction). The first gate metal layer may be made up of a single layer or multiple layers of one of molybdenum (Mo), aluminum (Al), chromium (Cr), gold (Au), titanium (Ti), nickel (Ni), neodymium (Nd), and/or copper (Cu) or an alloy thereof.

The first interlayer dielectric layer 141 may be located on the first gate metal layer. The first interlayer dielectric layer 141 may include an inorganic layer, for example, a silicon nitride layer, a silicon oxynitride layer, a silicon oxide layer, a titanium oxide layer, or an aluminum oxide layer. The first interlayer dielectric layer 141 may include a number of inorganic films.

The second gate metal layer including a second capacitor electrode CAE2 of the capacitor Cst may be located on the first interlayer dielectric layer 141. The second capacitor electrode CAE2 may overlap the first capacitor electrode CAE1 in the third direction (z-axis direction). Therefore, the capacitor Cst may be formed by the first capacitor electrode CAE1, the second capacitor electrode CAE2, and an inorganic insulating dielectric film located between the electrodes and serving as a dielectric film. The second gate metal layer may be made up of a single layer or multiple layers of one of molybdenum (Mo), aluminum (Al), chromium (Cr), gold (Au), titanium (Ti), nickel (Ni), neodymium (Nd), and/or copper (Cu) or an alloy thereof.

A second interlayer dielectric layer 142 may be located on the second gate metal layer. The second interlayer dielectric layer 142 may include an inorganic layer, for example, a silicon nitride layer, a silicon oxynitride layer, a silicon oxide layer, a titanium oxide layer, or an aluminum oxide layer. The second interlayer dielectric layer 142 may include a number of inorganic films.

The first data metal layer including first connection electrodes CE1 and data lines may be arranged on the second interlayer dielectric layer 142. The first connection electrode CE1 may be connected to the drain region TD through a first contact hole CT1 penetrating the gate insulator 130, the first interlayer dielectric layer 141 and the second interlayer dielectric layer 142. The first data metal layer may be made up of a single layer or multiple layers of one of molybdenum (Mo), aluminum (Al), chromium (Cr), gold (Au), titanium (Ti), nickel (Ni), neodymium (Nd), and/or copper (Cu) or an alloy thereof.

A first organic layer 160 may be located over the first connection electrode CE1 for providing a flat surface over the thin-film transistors TFT having different heights. The first organic layer 160 may be formed as an organic layer, such as an acryl resin, an epoxy resin, a phenolic resin, a polyamide resin, and/or a polyimide resin.

A second data metal layer including second connection electrodes CE2 may be located on the first organic layer 160. The second data metal layer may be connected to the first connection electrode CE1 through a second contact hole CT2 penetrating the first organic layer 160. The second data metal layer may be made up of a single layer or multiple layers of one of molybdenum (Mo), aluminum (Al), chromium (Cr), gold (Au), titanium (Ti), nickel (Ni), neodymium (Nd), and/or copper (Cu) or an alloy thereof.

The second organic layer 180 may be located on the second connection electrode CE2. The second organic layer 180 may be formed as an organic layer, such as an acryl resin, an epoxy resin, a phenolic resin, a polyamide resin, and/or a polyimide resin.

It should be noted that the second data metal layer including the second connection electrodes CE2 and the second organic layer 180 may be eliminated.

The emission material layer EML is located on the thin-film transistor layer TFTL. The emission material layer EML may include light-emitting elements LEL and a pixel-defining layer 190.

Each of the light-emitting elements LEL may include a pixel electrode 171, an emissive layer 172, and a common electrode 173. In each of the emission areas EA, the pixel electrode 171, the emissive layer 172 and the common electrode 173 are stacked on one another sequentially, so that holes from the pixel electrode 171 and electrons from the common electrode 173 are combined with each other in the emissive layer 172 to emit light. In such case, the pixel electrode 171 may be an anode electrode while the common electrode 173 may be a cathode electrode.

A pixel electrode layer including the pixel electrode 171 may be formed on the second organic layer 180. The pixel electrode 171 may be connected to the second connection electrode CE2 through a third contact hole CT3 penetrating the second organic layer 180. The pixel electrode layer may be made up of a single layer or multiple layers of one of molybdenum (Mo), aluminum (Al), chromium (Cr), gold (Au), titanium (Ti), nickel (Ni), neodymium (Nd), and/or copper (Cu) or an alloy thereof.

In the top-emission architecture where light exits from the emissive layer 172 toward the common electrode 173, the pixel electrode 171 may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/AI/ITO), an APC alloy and a stack structure of APC alloy and ITO (ITO/APC/ITO) to increase the reflectivity. The APC alloy is an alloy of silver (Ag), palladium (Pd), and copper (Cu).

The pixel-defining layer 190 may define the emission areas EA of the pixels. To this end, the pixel-defining layer 190 may be formed on the second organic layer 180 to expose a part of the pixel electrode 171. The pixel-defining layer 190 may cover edges of the pixel electrodes 171. The pixel-defining layer 190 may be located inside the third contact hole CT3. In other words, the third contact hole CT3 may be filled with the pixel-defining layer 190. The pixel-defining layer 190 may be formed of an organic layer, such as an acryl resin, an epoxy resin, a phenolic resin, a polyamide resin, and/or a polyimide resin.

A spacer 191 may be located on the pixel-defining layer 190. The spacer 191 may support a mask during a process of fabricating the emissive layer 172. The spacer 191 may be implemented as an organic layer, such as an acryl resin, an epoxy resin, a phenolic resin, a polyamide resin, and/or a polyimide resin.

The emissive layer 172 is formed on the pixel electrode 171. The emissive layer 172 may include an organic material to emit light of a corresponding color. For example, the emissive layer 172 may include a hole transporting layer, an organic material layer, and an electron transporting layer. The organic material layer may include a host and a dopant. The organic material layer may include a material that emits a predetermined light, and may be formed using a phosphor or a fluorescent material.

The common electrode 173 is formed on the emissive layer 172. The common electrode 173 may cover the emissive layer 172. The common electrode 173 may be a common layer formed across the emission areas EA. A capping layer may be formed on the common electrode 173.

In the top-emission structure, the common electrode 173 may be formed of a transparent conductive material (TCP), such as ITO and IZO that can transmit light, or a semi-transmissive conductive material, such as magnesium (Mg), silver (Ag) and an alloy of magnesium (Mg) and silver (Ag). When the common electrode 173 is made of a semi-transmissive metal material, the light extraction efficiency can be increased by using microcavities.

The encapsulation layer ENC may be placed on the emission material layer EML. The encapsulation layer ENC may include one or more inorganic films TFE1 and TFE3 to reduce or prevent permeation of oxygen or moisture into the emission material layer EML. In addition, the encapsulation layer ENC may include at least one organic film to protect the emission material layer EML from particles, such as dust. For example, the encapsulation layer ENC may include a first inorganic encapsulation film TFE1, an organic encapsulation film TFE2 and a second inorganic encapsulation film TFE3.

The first inorganic encapsulation film TFE1 may be located on the common electrode 173, the organic encapsulation film TFE2 may be located on the first inorganic encapsulation film TFE1, and the second inorganic encapsulation film TFE3 may be located on the organic encapsulation film TFE2. The first inorganic encapsulation film TFE1 and the second inorganic encapsulation film TFE3 may be made up of multiple layers in which one or more inorganic layers of a silicon nitride layer, a silicon oxynitride layer, a silicon oxide layer, a titanium oxide layer and an aluminum oxide layer are alternately stacked on one another. The organic encapsulation film TFE2 may be an organic film, such as an acryl resin, an epoxy resin, a phenolic resin, a polyamide resin, a polyimide resin, etc.

The sensor electrode layer SENL may be located on the encapsulation layer ENC. The sensor electrode layer SENL may include a second buffer film BF2, a first bridge BE1, a first sensor-insulating film TINS1, sensor electrodes TE and RE, and a second sensor-insulating film TINS2.

A second buffer film BF2 may be located on the encapsulation layer ENC. The second buffer film BF2 may include at least one inorganic film. For example, the second buffer film BF2 may be made up of multiple layers in which one or more inorganic layers of a silicon nitride layer, a silicon oxynitride layer, a silicon oxide layer, a titanium oxide layer and an aluminum oxide layer are alternately stacked on one another. The second buffer film BF2 may be eliminated.

First bridge electrodes BE1 may be located on the second buffer film BF2. The first bridge electrodes BE1 may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/Al/ITO), an APC alloy and a stack structure of an APC alloy and ITO (ITO/APC/ITO).

A first sensor-insulating layer TINS1 may be located on the first bridge electrodes BE1. The first sensor-insulating layer TINS1 may be formed of an inorganic layer, for example, a silicon nitride layer, a silicon oxynitride layer, a silicon oxide layer, a titanium oxide layer, or an aluminum oxide layer.

The sensor electrodes (e.g., driving electrodes TE and sensing electrodes RE) may be arranged on the first sensor-insulating layer TINS1. In addition, dummy patterns may be arranged on the first sensor-insulating layer TNIS1. The driving electrodes TE, the sensing electrodes RE and the dummy patterns do not overlap the emission areas EA. The driving electrodes TE, the sensing electrodes RE and the dummy patterns may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/Al/ITO), an APC alloy and a stack structure of an APC alloy and ITO (ITO/APC/ITO).

The second sensor-insulating layer TINS2 may be located on the driving electrodes TE, the sensing electrodes RE, and the dummy patterns. The second sensor-insulating layer TINS2 may include at least one of an inorganic film or an organic film. The inorganic film may be a silicon nitride layer, a silicon oxynitride layer, a silicon oxide layer, a titanium oxide layer, or an aluminum oxide layer. The organic film may be an acryl resin, an epoxy resin, a phenolic resin, a polyamide resin, and/or a polyimide resin.

The polarizing film PF may be located on the sensor electrode layer SENL. The polarizing film PF may be located on the display panel 100 to reduce reflection of external light. The polarizing film PF may include a first base member, a linear polarizer, a retardation film, such as a λ/4 (quarter-wave) plate, and a second base member. The first base member, the retardation film, the linear polarizer and the second base member of the polarizing film PF may be sequentially stacked on the display panel 100.

The cover window CW may be located on the polarizing film PF. The cover window CW may be attached onto the polarizing film PF by a transparent adhesive member, such as an optically clear adhesive (OCA) film.

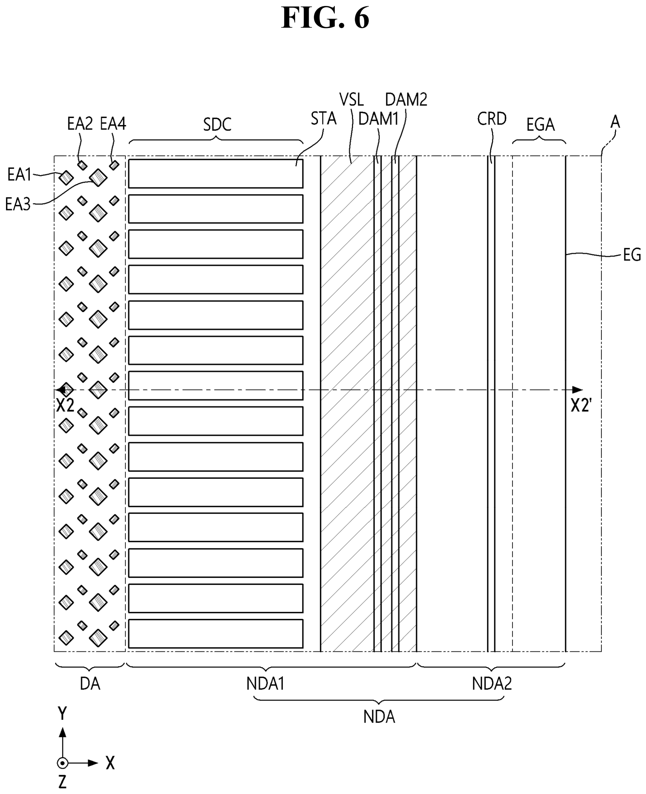

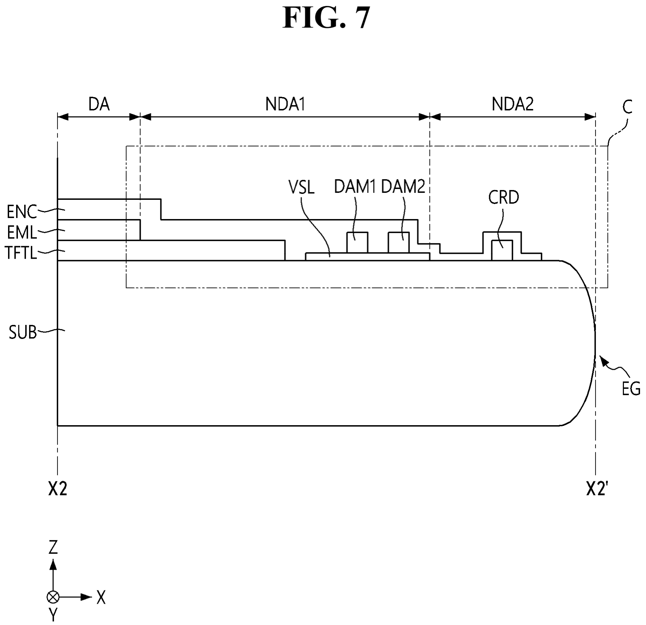

FIG. 6 is an enlarged view of area A of FIG. 2. FIG. 7 is a cross-sectional view taken along the line X2 - X2' of FIG. 6.

Referring to FIGS. 6 and 7 in conjunction with FIG. 5, the display area DA may include a plurality of emission areas EA1, EA2, EA3 and EA4. The plurality of emission areas EA1, EA2, EA3 and EA4 may include a first emission area EA1 emitting light of a first color, a second emission area EA2 and a fourth emission area EA4 emitting light of a second color, and a third emission area EA3 emitting light of a third color. For example, the light of the first color may be light in a red wavelength range of approximately 600 nm to approximately 750 nm, the light of the second color may be light in a green wavelength range of approximately 480 nm to approximately 560 nm, and the light of the third color may be light in a blue wavelength range of approximately 370 nm to approximately 460 nm. It should be understood, however, that the present disclosure is not limited thereto.

Although the second emission area EA2 and the fourth emission area EA4 emit light of the same color (e.g., the light of the second color in the example shown in FIG. 6), the embodiments of the present disclosure are not limited thereto. The second emission area EA2 and the fourth emission area EA4 may emit lights of different colors. For example, the second emission area EA2 may emit light of the second color, and the fourth emission area EA4 may emit light of a fourth color.

In addition, although each of the first emission areas EA1, the second emission areas EA2, the third emission areas EA3 and the fourth emission areas EA4 may have a rectangular shape when viewed from the top in the example shown in FIG. 6, the embodiments of the present disclosure are not limited thereto. Each of the first emission areas EA1, the second emission areas EA2, the third emission areas EA3, and the fourth emission areas EA4 may have other polygonal shape than a quadrangular shape, a circular shape, or an elliptical shape when viewed from the top.

According to some embodiments, the third emission area EA3 may be the largest, while the second emission area EA2 and the fourth emission area EA4 may be the smallest. The second emission area EA2 and the fourth emission area EA4 may have the same size. It should be understood, however, that the embodiments of the present disclosure are not limited thereto.

The second emission areas EA2 and the fourth emission areas EA4 may be arranged alternately in the first direction (x-axis direction). The second emission areas EA2 may be arranged in the second direction (y-axis direction). The fourth emission areas EA4 may be arranged in the second direction (y-axis direction).

The first emission areas EA1 and the third emission areas EA3 may be arranged alternately in the first direction (x-axis direction). The first emission areas EA1 may be arranged in the second direction (y-axis direction). The third emission areas EA3 may be arranged in the second direction (y-axis direction). Each of the first emission areas EA1 and the third emission areas EA3 may have a square shape when viewed from the top, but embodiments of the present disclosure are not limited thereto.

The non-display area NDA may include a first non-display area NDA1 and a second non-display area NDA2. In the first non-display area NDA1, structures for driving pixels of the display area DA may be arranged. The second non-display area NDA2 may be located on the outer side of the first non-display area NDA1. The second non-display area NDA2 may be the outer region of the non-display area NDA. In addition, the second non-display area NDA2 may be the outer region of the display panel 100.

The first non-display area NDA1 may include a scan driver circuit SDC, a first supply voltage line VSL, a first dam DAM1, and a second dam DAM2.

The scan driver circuit SDC may include a plurality of stages STA. The plurality of stages STA may be respectively connected to the scan lines of the display area DA extended in the first direction (x-axis direction). The plurality of stages STA may be respectively connected to the scan lines of the display area DA extended in the first direction (x-axis direction). The plurality of stages STA may sequentially apply scan signals to a plurality of scan lines.

The first supply voltage line VSL may be located on the outer side of the scan driver circuit SDC. That is to say, the first supply voltage line VSL may be located closer to an edge EG of the display panel 100 than the scan driver circuit SDC is. The first supply voltage line VSL may extend in the second direction (y-axis direction) in the non-display area NDA on the left side of the display panel 100.

The first supply voltage line VSL may be electrically connected to the common electrode 173, and accordingly the common electrode 173 may receive a first supply voltage from the first supply voltage line VSL.

The first dam DAM1 and the second dam DAM2 may be structures for reducing or preventing overflow of the organic encapsulation film TFE2 of the encapsulation layer ENC to the edge EG of the display panel 100.

The first dam DAM1 may surround the display area DA, and the second dam DAM2 may surround the first dam DAM1. For example, as shown in FIG. 6, the first dam DAM1 and the second dam DAM2 may extend in the second direction (y-axis direction) in the non-display area NDA on the right side of the display panel 100. The second dam DAM2 may be located on the outer side of the first dam DAM1. In one or more embodiments, the first dam DAM1 and the second dam DAM2 may also be located in the non-display area NDA on the upper, lower, and left sides of the display panel 100. The first dam DAM1 and the second dam DAM2 may extend in the second direction (y-axis direction) in the non-display area NDA on the left side of the display panel 100, and may extend in the first direction (x-axis direction) in the non-display area NDA on the upper and lower sides of the display panel 100.

The first dam DAM1 may be closer to the scan driver circuit SDC than the second dam DAM2 is, and the second dam DAM2 may be closer to the edge EG of the display panel 100 than the first dam DAM1 is.

Although the first dam DAM1 and the second dam DAM2 are placed on the first supply voltage line VSL in the example shown in FIG. 6, the embodiments of the present disclosure are not limited thereto. For example, one of the first dam DAM1 or the second dam DAM2 may not be placed on the first supply voltage line VSL. Alternatively, none of the first dam DAM1 and the second dam DAM2 may be placed on the first supply voltage line VSL. In this instance, the first dam DAM1 and the second dam DAM2 may be located on the outer side of the first supply voltage line VSL1.

In addition, although the display panel 100 includes the two dams DAM1 and DAM2 according to the one or more embodiments corresponding to FIG. 6, the embodiments of the present disclosure are not limited thereto. For example, a display panel 100 according to one or more embodiments may include three or more dams.

In some embodiments, the second non-display area NDA2 may include a crack dam CRD.

The crack dam CRD may be a structure for reducing or preventing cracks in the inorganic films of the encapsulation layer ENC from propagating during a process of cutting the substrate SUB in the process of fabricating the display device 10. The crack dam CRD may be located in the second non-display area NDA2 and may be located more to the outside than the first dam DAM1 and the second dam DAM2. For example, the crack dam CRD may be closer to the edge EG of the display panel 100 than the first dam DAM1 and the second dam DAM2.

The crack dam CRD may be arranged along the left, upper and right edges of the display panel 100. For example, as shown in FIG. 6, the crack dam CRD may extend in the second direction (y-axis direction) in the non-display area NDA on the right side of the display panel 100. In one or more embodiments, the crack dam CRD may also be arranged in the non-display area NDA on the upper and left sides of the display panel 100. The crack dam CRD may extend in the second direction (y-axis direction) in the non-display area NDA on the left side of the display panel 100 and may extend in the first direction (x-axis direction) in the non-display area NDA on the upper side of the display panel 100. The crack dam CRD may not be arranged at the lower edge of the display panel 100. It should be understood, however, that the embodiments of the present disclosure are not limited thereto. According to one or more other embodiments, the crack dam CRD may also be arranged in the non-display area NDA on the lower side of the display panel 100, in which case the crack dam CRD may extend in the first direction (x-axis direction). In some embodiments, the crack dam CRD may be the outermost structure located at the outermost position of the display panel 100.

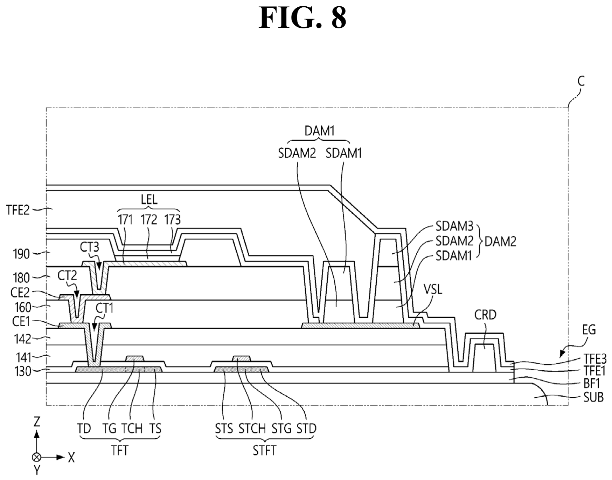

FIG. 8 is an enlarged view of area C of FIG. 7.

Referring to FIG. 8, the first supply voltage line VSL may include the same material as the first data metal layer including the first connection electrode CE1 and the data lines, and may be located on, or at, the same layer. The first supply voltage line VSL may be placed on the second interlayer dielectric layer 142. The first supply voltage line VSL may be made up of a single layer or multiple layers of one of molybdenum (Mo), aluminum (Al), chromium (Cr), gold (Au), titanium (Ti), nickel (Ni), neodymium (Nd), and/or copper (Cu) or an alloy thereof.

The first dam DAM1 and the second dam DAM2 may be arranged on the first supply voltage line VSL. The first dam DAM1 may include a first sub-dam SDAM1 and a second sub-dam SDAM2, and the second dam DAM2 may include a first sub-dam SDAM1, a second sub-dam SDAM2, and a third sub-dam SDAM3. The first sub-dam SDAM1 may include the same material as the first organic layer 160 and may be located on, or at, the same layer. The second sub-dam SDAM1 may include the same material as the second organic layer 180 and may be located on, or at, the same layer. The third sub-dam SDAM3 may include the same material as the pixel-defining layer 190 and may be located in, or at, the same layer.

The height of the first dam DAM1 may be lower than the height of the second dam DAM2, but the embodiments of the present disclosure are not limited thereto. The height of the first dam DAM1 may be substantially equal to or higher than the height of the second dam DAM2.

The common electrode 173 may be connected to a part of the first supply voltage line VSL that is exposed without being covered by the first organic layer 160, the second organic layer 180 and the first dam DAM1. Accordingly, the common electrode 173 may receive the first supply voltage from the first supply voltage line VSL.

The first inorganic encapsulation film TFE1 may cover the first dam DAM1, the second dam DAM2 and the crack dam CRD in the non-display area NDA. It should be understood, however, that the embodiments of the present disclosure are not limited thereto. In some embodiments, the first inorganic encapsulation film TFE1 may not cover at least one of the second dam DAM2 or the crack dam CRD.

The side of the first inorganic encapsulation film TFE1 may be aligned and coincident with the side of the substrate SUB at the edge EG of the display panel 100, but the present disclosure is not limited thereto.

The organic encapsulation film TFE2 may cover the upper surface of the first dam DAM1, but might not cover the upper surface of the second dam DAM2. It should be understood, however, that the present disclosure is not limited thereto. The organic encapsulation film TFE2 may cover neither the top surface of the first dam DAM1 nor the top surface of the second dam DAM2. It is possible to reduce or prevent overflow of the organic encapsulation film TFE2 to the edge EG of the display panel 100 by virtue of the first dam DAM1 and the second dam DAM2.

The second inorganic encapsulation film TFE3 may cover the first dam DAM1, the second dam DAM2 and the crack dam CRD in the non-display area NDA. It should be understood, however, that the embodiments of the present disclosure are not limited thereto. In some embodiments, the second inorganic encapsulation film TFE3 may not cover at least one of the second dam DAM2 or the crack dam CRD.

The side of the second inorganic encapsulation film TFE3 may be aligned and coincident with the side of the substrate SUB at the edge EG of the display panel 100, but the present disclosure is not limited thereto.

There may be formed an inorganic encapsulation area from the second dam DAM2 to the edge EG of the display panel 100, in which the first inorganic encapsulation film TFE1 and the second inorganic encapsulation film TFE3 are in contact with each other. The inorganic encapsulation area may surround the second dam DAM2.

Incidentally, in FIG. 8, a scan thin-film transistor STFT of the scan driver circuit SDC is illustrated. Because the scan thin-film transistor STFT is substantially identical to the thin-film transistor TFT described above with reference to FIG. 5; and, therefore, the scan thin-film transistor STFT will not be described.

The crack dam CRD may include the same material as the first organic layer 160. The crack dam CRD may be placed on the first buffer film BF1. The crack dam CRD may be formed as an organic layer, such as an acryl resin, an epoxy resin, a phenolic resin, a polyamide resin, and/or a polyimide resin.

Although the crack dam CRD includes one organic film layer in the example shown in FIG. 8, the embodiments of the present disclosure are not limited thereto. For example, the crack dam CRD may further include another organic film layer including the same material as the second organic layer 180. Alternatively, the crack dam CRD may further include yet another organic film layer including the same material as the pixel-defining layer 190. Alternatively, the crack dam CRD may further include yet another organic film layer including the same material as the spacer 191 (see FIG. 5).

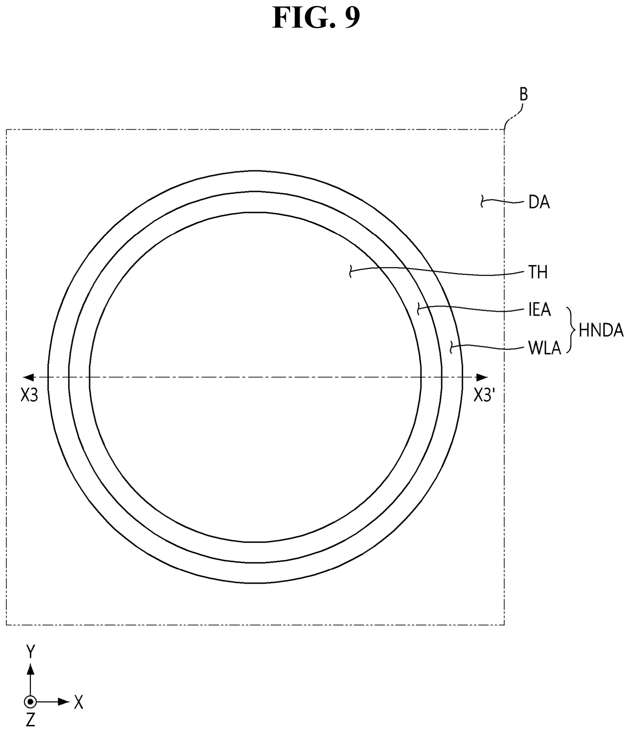

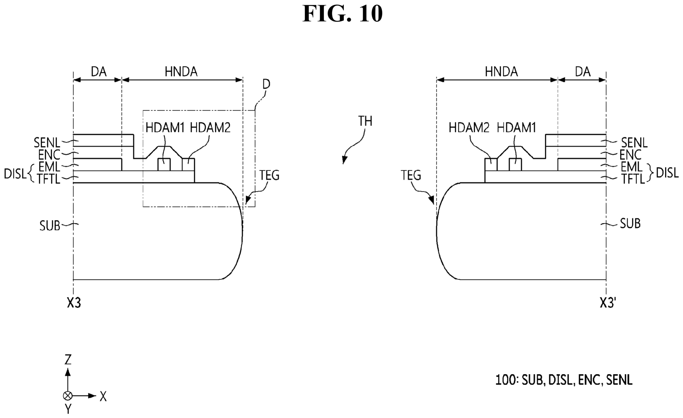

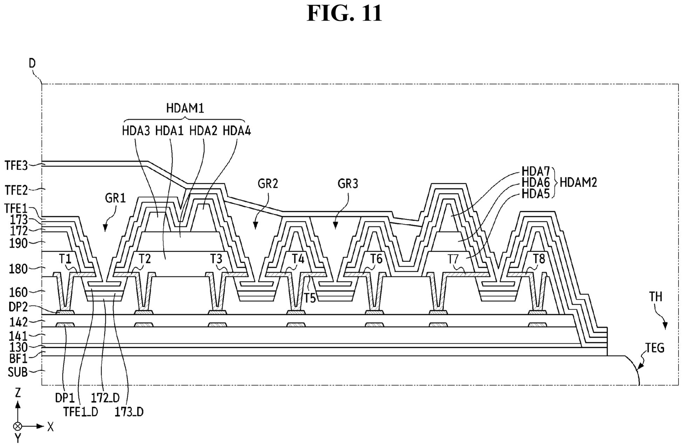

FIG. 9 is an enlarged view of area B of FIG. 2. FIG. 10 is a cross-sectional view, taken along the line X3 - X3' in FIG. 9. FIG. 11 is an enlarged view of area D of FIG. 10.

Referring to FIGS. 9 and 11, the display panel 100 may include a hole non-display area HNDA surrounding a through hole TH. The hole non-display area HNDA may include an inorganic encapsulation area IEA and a wiring area WLA surrounding the inorganic encapsulation area IEA.

In the inorganic encapsulation area IEA, the first inorganic encapsulation film TFE1 and the second inorganic encapsulation film TFE3 of the encapsulation layer ENC come in contact with each other to reduce or prevent permeation of oxygen or moisture into the emission material layer EML of the display layer DISL due to the through hole TH.

The inorganic encapsulation area IEA may include at least one dam, at least one tip, and at least one groove. For example, the inorganic encapsulation area IEA may include a first hole dam HDAM1, a second hole dam HDAM2, first to eighth tips T1 to T8, and first to third grooves GR1 to GR3 as shown in FIG. 11.

The first tip T1 and the second tip T2 may be closer to the wiring area WLA than the first hole dam HDAM1. The first tip T1 may be closer to the wiring area WLA than the second tip T2. The second tip T2 may be located between the first tip T1 and the first dam HDAM1.

The third tip T3, the fourth tip T4, the fifth tip T5, and the sixth tip T6 may be arranged between the first hole dam HDAM1 and the second hole dam HDAM2 (e.g., between in plan view). At least a part of the third tip T3 may overlap with the first hole dam HDAM1 in the third direction (z-axis direction).

The seventh tip T7 and the eighth tip T8 may be closer to the through hole TH than the second dam HDAM2. At least a part of the seventh tip T7 may overlap with the second hole dam HDAM2 in the third direction (z-axis direction). The eighth tip T8 may be located between the second hole dam HDAM2 and the through hole TH.

A first groove GR1 may be located between the first tip T1 and the second tip T2. A second groove GR2 may be located between the third tip T3 and the fourth tip T4. A third groove GR3 may be located between the fifth tip T5 and the sixth tip T6.

In the wiring area WLA, lines are extended around the through hole TH. Some of such lines may be connected to the data lines, while some others of them may be connected to a second supply voltage line from which a second supply voltage higher than the first supply voltage is applied. Still some others of them may be connected to the scan lines. The wiring area WLA may be surrounded by the display area DA.

A first dummy pattern DP1 may include the same material as the second gate metal layer including the second capacitor electrode CAE2 of the capacitor Cst, and may be located on, or at, the same layer. For example, the first dummy pattern DP1 may be located on the first interlayer dielectric layer 141. The first dummy pattern DP1 may be made up of a single layer or multiple layers of one of molybdenum (Mo), aluminum (Al), chromium (Cr), gold (Au), titanium (Ti), nickel (Ni), neodymium (Nd), and/or copper (Cu) or an alloy thereof.

A second dummy pattern DP2 may include the same material as the first data metal layer including the first connection electrode CE1 and the data lines, and may be placed in, or at, the same layer. For example, the second dummy pattern DP2 may be placed on the second interlayer dielectric layer 142. The second dummy pattern DP2 may be made up of a single layer or multiple layers of one of molybdenum (Mo), aluminum (Al), chromium (Cr), gold (Au), titanium (Ti), nickel (Ni), neodymium (Nd), and/or copper (Cu) or an alloy thereof.

The second dummy pattern DP2 may overlap with the first dummy pattern DP1 in the third direction (z-axis direction).

The first to eighth tips T1 to T8 may include the same material as the second data metal layer including the second connection electrode CE2 and may be arranged on, or at, the same layer. For example, the first to eighth tips T1 to T8 may be located on the first organic layer 160. The first to eighth tips T1 to T8 may be made up of a single layer or multiple layers of one of molybdenum (Mo), aluminum (Al), chromium (Cr), gold (Au), titanium (Ti), nickel (Ni), neodymium (Nd), and/or copper (Cu) or an alloy thereof.

Each of the first to eighth tips T1 to T8 may be connected to the second dummy pattern(s) DP2 through a contact hole penetrating the first organic layer 160. Each of the first to eighth tips T1 to T8 may include an eaves structure that has an upper surface and a lower surface that are exposed without being covered by the first organic layer 160, the second organic layer 180, the first hole dam HDAM1, and the second hole dam HDAM2. The fourth tip T4 and the fifth tip T5 may be formed integrally. Each of the first to eighth tips T1 to T8 may be a protrusion pattern or a trench pattern for forming a groove (or trench). The distance from the eighth tip T8 to the edge TEG of the through hole TH may be approximately 300 µm. It should be understood, however, that the embodiments of the present disclosure are not limited thereto.

The first groove GR1 may be formed between the first tip T1 and the second tip T2, the second groove GR2 may be formed between the third tip T3 and the fourth tip T4, and the third groove GR3 may be formed between the fifth tip T5 and the sixth tip T6. The first groove GR1 may have eaves structures formed by the first tip T1 and the second tip T2, the second groove GR2 may have eaves structures formed by the third tip T3 and the fourth tip T4, and the third groove GR3 may have eaves structures formed by the fifth tip T5 and the sixth tip T6.

Because the emissive layer 172 is deposited by evaporation and the common electrode 173 is deposited by sputtering, the step coverage is low, and thus it may be broken in each of the first to third grooves GR1, GR2 and GR3. On the other hand, because the first inorganic encapsulation film TFE1 and the second inorganic encapsulation film TFE3 are deposited by chemical vapor deposition, atomic layer deposition, etc., they have a high step coverage and thus may not be disconnected in each of the first to third grooves GR1, GR2, and GR3. For example, in each of the first to third grooves GR1, GR2, and GR3, there may be a residue 172_D disconnected from the emissive layer, and a residue 173_D disconnected from the common electrode. Herein, the step coverage refers to a ratio of a thin film applied on an inclined portion to the thin film applied on a flat portion.

The first hole dam HDAM1 may include first to fourth hole sub-dams HDA1, HDA2, HDA3, and HDA4. The first hole sub-dam HDA1 may be placed on the first organic layer 160 and may include the same material as the second organic layer 180. The first hole sub-dam HDA1 may be placed on the second tip T2 and the third tip T3. The second hole sub-dam HDA2 may be placed on the first hole sub-dam HDA1 and may include the same material as the pixel-defining layer 190. The third hole sub-dam HDA3, and the fourth hole sub-dam HDA4 may be placed on the second hole sub-dam HDA2 and may include the same material as the spacer 191. It should be understood, however, that the present disclosure is not limited thereto. The fourth hole sub-dam HDA4 may be closer to the through hole TH than the third hole sub-dam HDA3. The thickness of the fourth hole sub-dam HDA4 may be greater than the thickness of the third hole sub-dam HDA3.

The second hole dam HDAM2 may include fifth to seventh hole sub-dams HDA5, HDA6 and HDA7. The fifth hole sub-dam HDA5 may be located on the first organic layer 160 and may include the same material as the second organic layer 180. The fifth hole sub-dam HDA5 may be located on the seventh tip T7. The sixth hole sub-dam HDA6 may be placed on the fifth hole sub-dam HDA5 and may include the same material as the pixel-defining layer 190. The seventh hole sub-dam HDA7 may be located on the sixth hole sub-dam HDA6 and may include the same material as the spacer 191. It should be understood, however, that the present disclosure is not limited thereto.

It is possible to reduce or prevent the likelihood of the organic encapsulation film TFE2 from overflowing into the through hole TH by virtue of the first hole dam HDAM1 and the second hole dam HDAM2.

The residue 172_D, the residue 173_D, the first inorganic encapsulation film TFE1, and the second inorganic encapsulation film TFE3 may extend to the edge TEG of the through hole TH. The end of the residue 172_D, the end of the residue 173_D, the end of the first inorganic encapsulation film TFE1 and the end of the second inorganic encapsulation film TFE3 may be aligned with the edge TEG of the through hole TH. It should be understood, however, that the embodiments of the present disclosure are not limited thereto. The end of the residue 172_D, the end of the residue 173_D, the end of the first inorganic encapsulation film TFE1 and the end of the second inorganic encapsulation film TFE3 may not be aligned with the edge TEG of the through hole TH.

As shown in FIG. 11, the emissive layer 172 and the common electrode 173 are disconnected in each of the first to third grooves GR1, GR2 and GR3 formed by the first to eighth tips T1 to T8, it is possible to reduce or prevent the likelihood that oxygen, moisture, etc., permeate through the emissive layer 172 and the common electrode 173 exposed via the through hole TH.

Referring back to FIG. 7, to reduce or minimize the distance from the crack dam CRD to the edge EG of the display panel 100 (or the width of the second non-display area NDA2), a process of irradiating laser and then spraying an etchant to cut the substrate SUB of the display panel 100 may be carried out. When the substrate SUB of the display panel 100 is cut by irradiating the laser and then spraying the etchant, the width of the second non-display area NDA2 can be greatly reduced. In other words, the width of the non-display area NDA can be reduced.

Likewise, referring back to FIG. 10, to reduce or minimize the distance from the second hole dam HDAM2 to the edge TEG of the through hole TH (or the width of the hole non-display area HNDA), a process of irradiating laser and then spraying an etchant to form the through hole TH may be carried out. By irradiating laser and then spraying an etchant to form the through hole TH, the width of the hole non-display area HNDA can be greatly reduced. In other words, the width of the hole non-display area HNDA can be reduced or minimized.

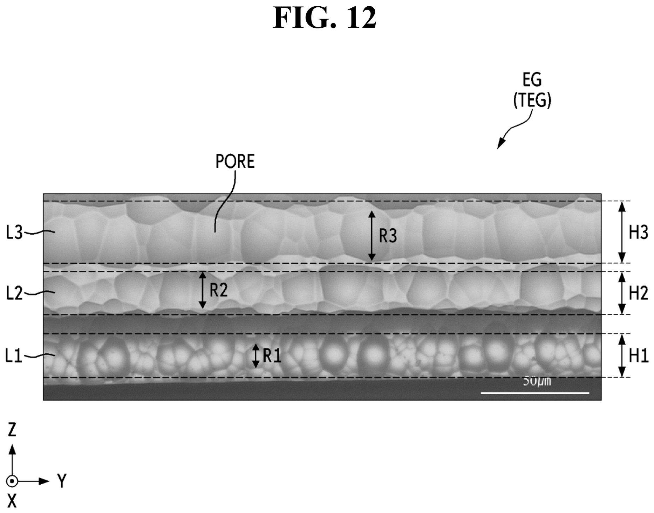

FIG. 12 is a side view showing an example of a side surface of an edge of a display panel and a side surface of an edge of a through hole according to one or more embodiments.

Referring to FIG. 10 in conjunction with FIGS. 7 and 10, an image shows a side surface of an edge EG of the display panel 100 and a side surface of an edge TEG of the through hole TH. Because the side surface of the edge EG of the display panel 100 and the side surface of the edge TEG of the through hole TH share substantially the same technical idea, the side surface of the edge EG of the display panel 100 will be described as an example.

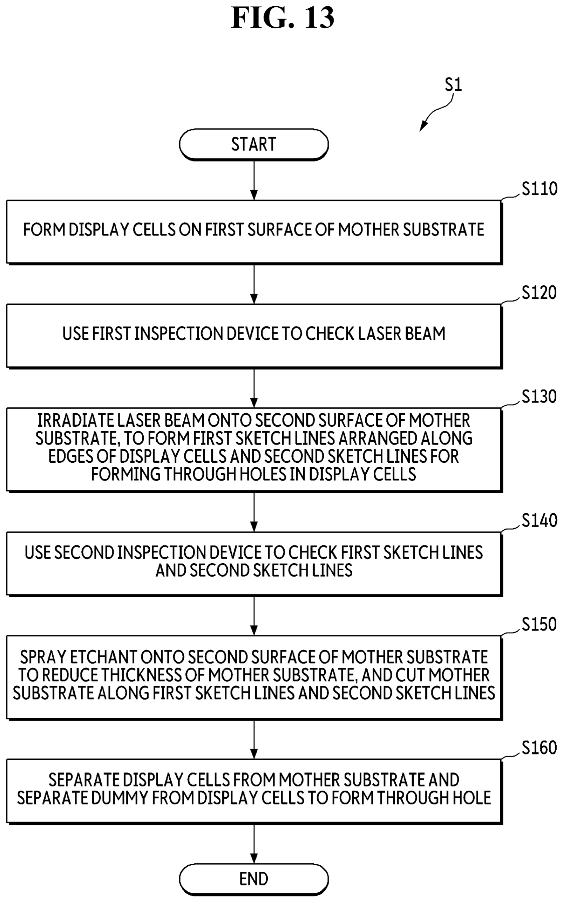

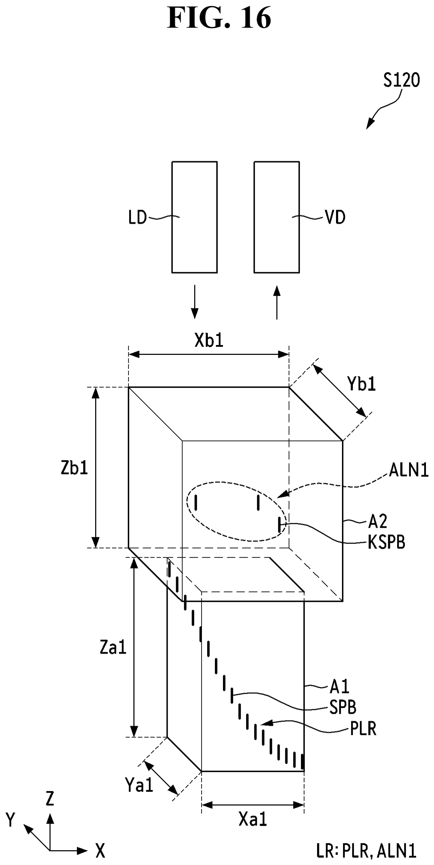

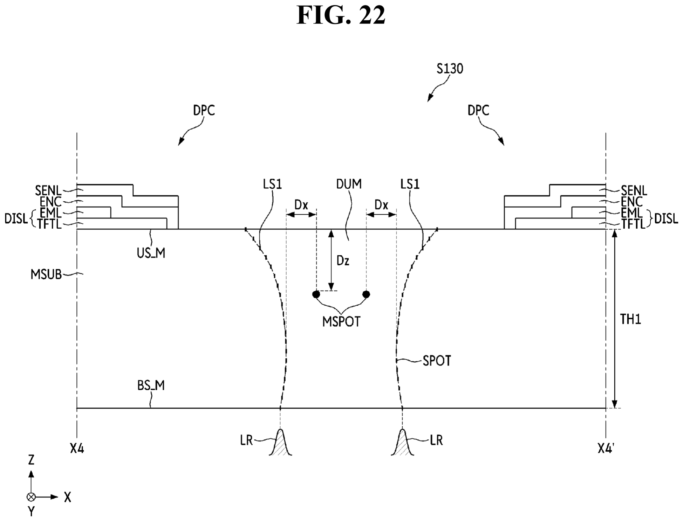

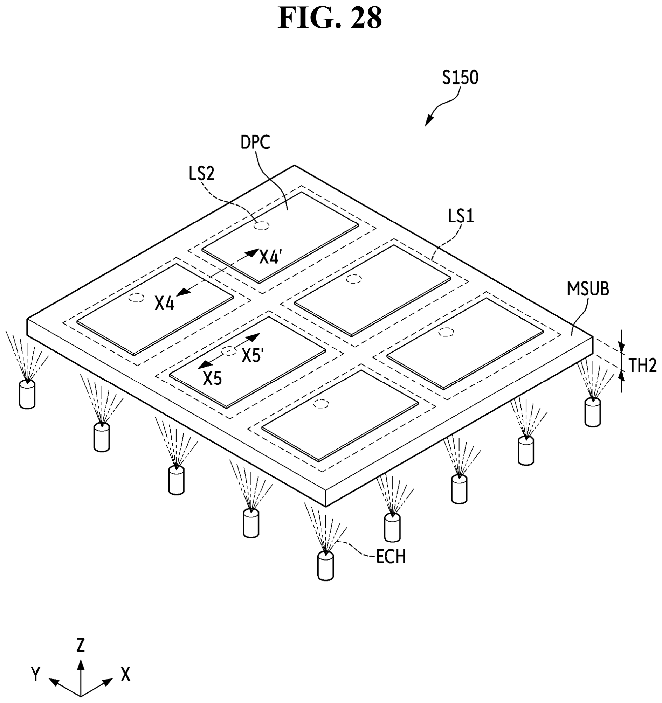

The side surface of the edge EG of the display panel 100 may include processing marks PORE. A processing mark PORE may be a trace formed by a laser-sketch process and an etching process in a method S1 for fabricating a display device described later (see FIG. 13). The processing marks PORE may be formed by etching a plurality of spots SPOT (see FIG. 22) formed by a plurality of spot beams SPB (see FIG. 16) in the laser-sketch process with an etchant ECH (see FIG. 28) in an etching process.

The shape and size of the processing mark PORE may vary depending on the shape, size and distance of the plurality of SPOT (see FIG. 22) and the etching conditions. In some embodiments, as shown in FIG. 12, the side surface of the edge EG of the display panel 100 may include a first layer L1, a second layer L2, and a third layer L3 that are stacked on one another from the bottom to the top. Although the side surface of the edge EG of the display panel 100 has three layers in the drawings, the present disclosure is not limited thereto. The side surface of the edge EG of the display panel 100 may have fewer than or more than three layers.

The first layer L1 may have a first height H1, the second layer L2 may have a second height H2, and the third layer L3 may have a third height H3. According to some embodiments, an upper one of the layers of the side surface of the edge EG of the display panel 100 may have a larger thickness than a lower one. For example, the first height H1 of the first layer L1 may be less than the second height H2 of the second layer L2, and the second height H2 of the second layer L2 may be less than the third height H3 of the third layer L3.

The size of the processing marks PORE included in the first layer L1 may have a first diameter R1, the size of the processing marks PORE included in the second layer L2 may have a second diameter R2, and the size of the processing marks PORE included in the third layer L3 may have a third diameter R3.

As used herein, the size of the processing marks PORE means the length in whichever direction having the largest size on the cross-section cut in the third direction (z-axis direction).

According to one or more embodiments of the present disclosure, the first diameter R1 may be approximately 25 µm or less, the second diameter R2 may be approximately 5 µm to approximately 35 µm, and the third diameter R3 may be approximately 10 µm to approximately 45 µm.

The average value of the first diameter R1 of the processing marks PORE included in the first layer L1 may be less than the average value of the second diameter R2 of the processing marks PORE included in the second layer L2, and the average value of the second diameter R2 of the processing marks PORE included in the second layer L2 may be less than the average value of the third diameter R3 of the processing marks PORE included in the third layer L3.

According to one or more embodiments of the present disclosure, the average value of the first diameter R1 of the processing marks PORE included in the first layer L1 may be approximately 15 µm, the average value of the second diameter R2 of the processing marks PORE included in the second layer L2 may be approximately 25 µm, and the average value of the third diameter R3 of the processing marks PORE included in the third layer L3 may be approximately 35 µm.

The deviations of the first diameter R1 of the processing marks PORE included in the first layer L1, the deviations of the second diameter R2 of the processing marks PORE included in the second layer L2, and the deviations of the third diameter R3 of the processing marks PORE included in the third layer L3 may be equal to or less than 25 µm.

As used herein, the deviations of the sizes of the processing marks PORE means the largest value among the differences between the sizes of the processing marks PORE and the average value.

The display device 10 can improve the uniformity of processing marks PORE by checking whether a laser beam LR (see FIG. 16) is aligned with the x-axis and y-axis, and by checking the z-axis deviations according to the method S1 for fabricating a display device described later (see FIG. 13). In this manner, the surfaces of the edge EG of the display panel 100 and the edge TEG of the through hole TH can be formed smoothly.

Hereinafter, a method for fabricating a display device according to one or more embodiments of the present disclosure will be described.

FIG. 13 is a flowchart for illustrating a method for fabricating a display device according to one or more embodiments of the present disclosure.

Referring to FIG. 13, a method S1 for fabricating a display device according to one or more embodiments of the present disclosure may include: forming a plurality of display cells on a first surface of a mother substrate (operation S110); checking a laser beam using a first inspection device (operation S120); irradiating the laser beam onto a second surface of the mother substrate to form a plurality of first sketch lines arranged along edges of the plurality of display cells and a plurality of second sketch lines for forming a through hole in each of the display cells (operation S130); checking the plurality of first sketch lines and the second sketch lines using a second inspection device (operation S140); spraying an etchant onto a second surface of the mother substrate to reduce the thickness of the mother substrate and cutting the mother substrate along the first sketch line and the second sketch line (operation S150); and separating a plurality of display cells from the mother substrate and separating a dummy from the plurality of display cells to form a through hole (operation S160).

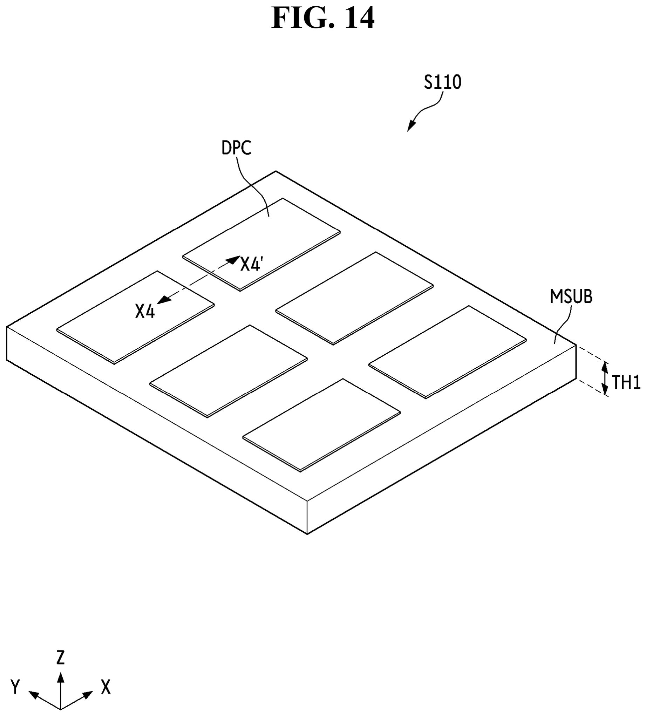

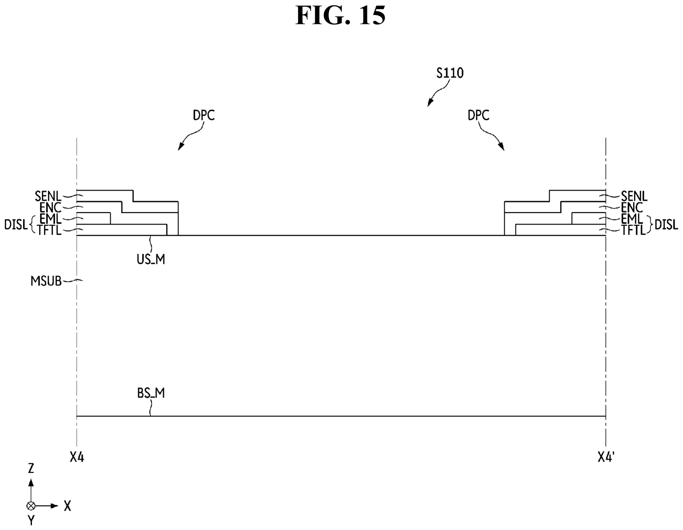

FIG. 14 is a perspective view for illustrating operation S110 of FIG. 13. FIG. 15 is a cross-sectional view, taken along the line X4 - X4' in FIG. 14.

Referring to FIGS. 14 and 15, a plurality of display cells DPC is formed on a first surface US_M of a mother substrate MSUB (operation S110 of FIG. 13).

The plurality of display cells DPC may include the same configurations as the display layer DISL, the encapsulation layer ENC, and the sensor electrode layer SENL of the display device 10 described above with reference to FIGS. 1 to 12, etc. The display layer DISL may include a thin-film transistor layer TFTL, and an emission material layer EML.

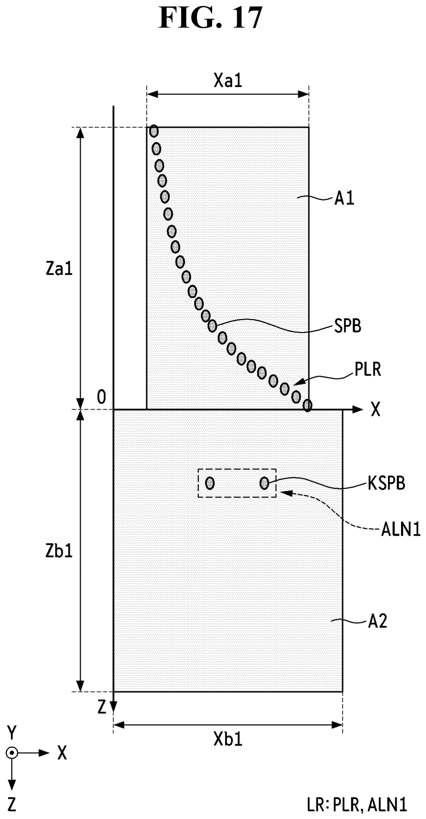

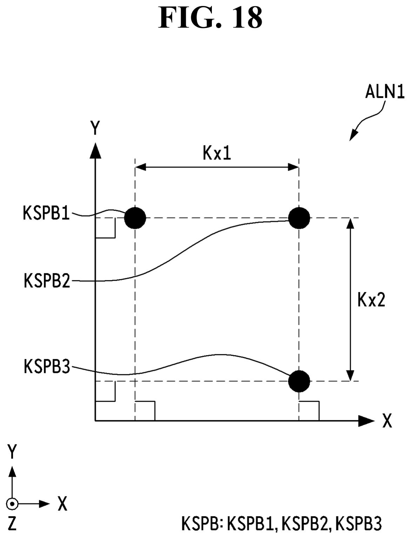

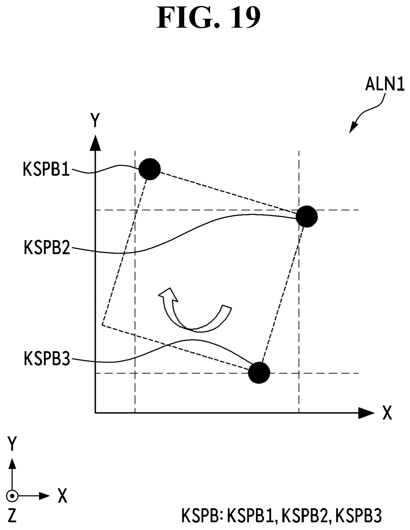

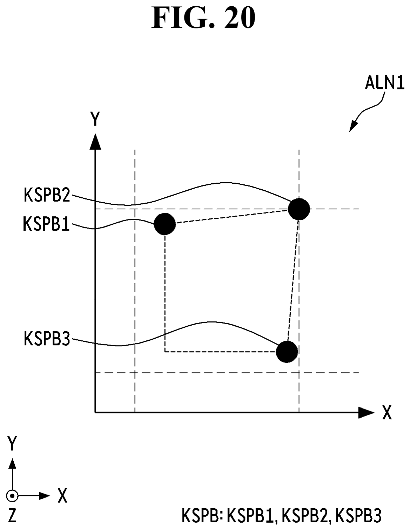

FIG. 16 is a perspective view for illustrating operation S120 of FIG. 13. FIG. 17 is a view schematically showing shapes of a laser beam and a first alignment key in the xz plane according to one or more embodiments. FIG. 18 is a view schematically showing a shape of a first alignment key in the xy plane according to one or more embodiments. FIGS. 19 and 20 are views for illustrating examples where first alignment keys are not aligned.

Referring to FIGS. 16 to 20, a laser beam LR may be checked using a first inspection device VD (S120 of FIG. 13).

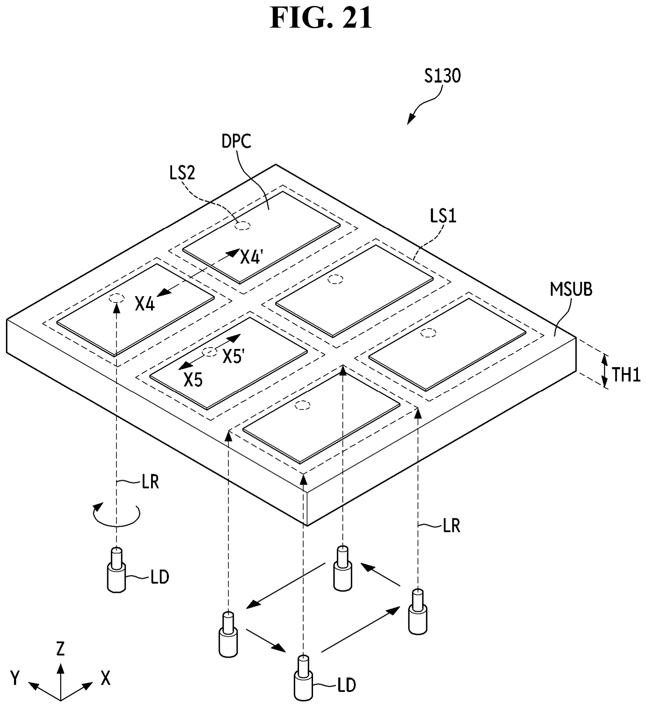

A laser-processing device LD may be a laser output device for forming sketch lines LS1 and LS2 on the mother substrate MSUB (see FIG. 21). The laser-processing device LD may include a light source to output a laser beam LR.

The light source may include a variety of laser-generating devices. The light source may output a laser beam LR. The light source may output the laser beam LR continuously or discontinuously. The light source may output a laser beam LR with a single pulse, or a laser beam LR with a burst pulse including a plurality of pulses.

The pulse duration, burst pulse, pulse energy, repetition rate, etc. of the laser beam LR may be controlled by the light source. For example, the pulse duration (or pulse width) of the laser beam LR may be approximately 300 fs (femto seconds) to approximately 10 ps (pico seconds). The pulse energy of the laser beam LR may be approximately 10 to approximately 70 µJ, and the processing energy per individual spot may be approximately 0.5 µJ to approximately 10 µJ. The repetition rate of the laser beam LR may be approximately 10 kHz to approximately 1,000 kHz. When the light source outputs the laser beam LR with burst pulses, the burst pulse of the laser beam LR may be about 2 to 5 pulses.

A variety of laser beams may be used as the laser beam LR according to one or more embodiments. Herein, the laser beam LR may be an infrared beam having a wavelength range of approximately 800 nm to approximately 1,100 nm.

The first inspection device VD may check the laser beam LR output by the laser-processing device LD. For example, the first inspection device VD may check the shape and alignment of the laser beam LR.

In some embodiments, the first inspection device VD may be a vision device, such as a beam profiler unit. For example, the first inspection device VD may include a camera and an objective lens.

The laser beam LR may include a processing laser beam PLR and a first alignment key ALN1.

The processing laser beam PLR may be a laser beam LR for forming sketch lines LS1 and LS2 on the mother substrate MSUB. The processing laser beam PLR may include a plurality of spot beams SPB. The plurality of spot beams SPB of the processing laser beam PLR may be arranged within a three-dimensional space defined by the first direction (x-axis direction), the second direction (y-axis direction), and the third direction (z-axis direction). That is to say, the processing laser beam PLR may be a laser beam LR having a three-dimensional shape.

In some embodiments, the plurality of spot beams SPB of the processing laser beam PLR may be arranged in a first area A1. The first area A1 may be a processing region for the processing laser beam PLR. According to one or more embodiments of the present disclosure, the length Xa1 of the first area A1 in the first direction (x-axis direction) may be approximately 200 µm, the length Ya1 of the first area A1 in the second direction (y-axis direction) may be approximately 200 µm, and the length Za1 of the first area A1 in the third direction (z-axis direction) may be approximately 500 µm. It should be understood, however, that the embodiments of the present disclosure are not limited thereto. The length Xa1 of the first area A1 in the first direction (x-axis direction), the length Ya1 of the first area A1 in the second direction (y-axis direction) and the length Za1 of the first area A1 in the third direction (z-axis direction) may vary depending on the thickness of the mother substrate MSUB to be processed and the shape of the edge EG of the display panel 100 and the edge TEG of the through hole TH after the processing.

The first alignment key ALN1 may be an alignment key for checking whether the positions of the laser beam LR on the x-axis and the y-axis are aligned. The first alignment key ALN1 may include a plurality of key spot beams KSPB. The plurality of key spot beams KSPB of the first alignment key ALN1 may be arranged within a two-dimensional space defined by the first direction (x-axis direction) and the second direction (y-axis direction). That is to say, the first alignment key ALN1 may be a two-dimensionally shaped laser beam LR.

In some embodiments, a plurality of key spot beams KSPB of the first alignment key ALN1 may be arranged in a second area A2. The second area A2 may be located above the first area A1. For example, the second area A2 may be located between the first area A1 and the first inspection device VD. In the second area A2, the first alignment key ALN1 may be arranged. The second area A2 may be formed to the extent that it does not affect the processing of the processing laser beam PLR and allows the first inspection device VD to capture images of the processing laser beam PLR as well as the first alignment key ALN1. According to one or more embodiments of the present disclosure, the length Xb1 of the second area A2 in the first direction (x-axis direction) may be approximately 500 µm, the length Yb1 of the second area A2 in the second direction (y-axis direction) may be approximately 500 µm, and the length Zb1 of the second area A2 in the third direction (z-axis direction) may be approximately 500 µm.

The center point of the first area A1 in the first direction (x-axis direction) and the second direction (y-axis direction) may be aligned with the center point of the second area A2 in the first direction (x-axis direction) and the second direction (y-axis direction). It should be understood, however, that the embodiments of the present disclosure are not limited thereto. In some embodiments, the upper surface of the first area A1 may be in direct contact with the upper surface of the second area A2.

To check the shape of the laser beam LR, the first inspection device VD may adjust the focus of the objective lens to focus on the z-axis positions (coordinates) of spot beams SPB and key spot beams KSPB of the laser beam LR. In this manner, the relative distance, relative position, shape, etc., between the spot beams SPB and the key spot beams KSPB may be checked. The first inspection device VD may check the relative distance, relative position, shape, etc., between the processing laser beam PLR and the first alignment key ALN1 by checking individual characteristics of the spot beams SPB and the key spot beams KSPB. That is to say, the first inspection device VD may check the shape of the entire laser beam LR.

To check whether the x-axis position and y-axis position of the laser beam LR are aligned, the first inspection device VD may adjust the focus of the objective lens to focus on the z-axis position (coordinate) of the first alignment key ALN1 of the laser beam LR.

As shown in FIGS. 18 to 20, the first inspection device VD may align the first alignment key ALN1 to a virtual grid and then check whether the x-axis position and y-axis position of the laser beam LR are aligned.

For example, in some embodiments, as shown in FIG. 18, a first key spot beam KSPB1 and a second key spot beam KSPB2 may be located on a straight line extended in the first direction (x-axis direction) on the grid, and the second key spot beam KSPB2 and a third key spot beam KSPB3 may be located on a straight line extended in the second direction (y-axis direction) on the grid. In this instance, it may be determined that the laser beam LR is correctly aligned. According to one or more embodiments of the present disclosure, the distance Kx1 between the first key spot beam KSPB1 and the second key spot beam KSPB2 in the first direction (x-axis direction) may be approximately 100 µm, and the distance Kx2 between the second key spot beam KSPB2 and the third key spot beam KSPB3 in the second direction (y-axis direction) may be approximately 100 µm. It should be understood, however, that the embodiments of the present disclosure are not limited thereto.

In another example as shown in FIG. 19, although a first key spot beam KSPB1, a second key spot beam KSPB2 and a third key spot beam KSPB3 form the vertices of a rectangle (or square), if the rectangle (or square) is rotated at a certain angle relative to a grid square, it can be seen that optical elements (or optical components) of the laser-processing device LD are rotated around the optical axis of the laser beam LR. In this instance, the laser beam LR can be properly aligned by rotating the optical elements or optical components) of the laser-processing device LD around the optical axis of the laser beam LR.

In another example as shown in FIG. 20, if a first key spot beam KSPB1, a second key spot beam KSPB2 a the third key spot beam KSPB3 do not form the vertices of a rectangle (or square) (e.g., do not coincide with a grid square), it can be determined that the optical axis of the laser beam LR itself is tilted or the optical elements (or components) themselves are deviated. In this instance, the laser beam LR can be properly aligned by adjusting the deviations of the optical elements (or optical components) of the laser-processing device LD.

By checking the shape of the laser beam LR, the relative positions of the processing laser beam PLR located in the first area A1 and the first alignment key ALN1 located in the second area A2 can be kept constant. Accordingly, it is possible to check the alignment of the entire laser beam LR including the processing laser beam PLR by checking only whether the first alignment key ALN1 is properly aligned or not.

The z-axis positions (coordinates) of the spot beams SPB of the processing laser beam PLR are all (or mostly) different, and thus it may be difficult to check the alignment of the spot beams SPB at once through the objective lens of the first inspection device VD. In contrast, the z-axis positions (coordinates) of the first key spot beam KSPB1, the second key spot beam KSPB2, and the third key spot beam KSPB3 included in the first alignment key ALN1 are all the same, and thus it is possible to suitably check whether the entire laser beam LR is aligned by adjusting the focus of the objective lens of the first inspection device VD once.

Therefore, in the method S1 for fabricating a display device according to one or more embodiments, it is possible to quickly and accurately check whether the x-axis position and y-axis position of the laser beam LR are properly aligned based on the first alignment key ALN1.

After the shape of the laser beam LR and the alignment of the x-axis position and the y-axis position have been checked, as described later with reference to FIG. 21, etc., the sketch lines LS1 and LS2 may be formed by irradiating the laser beam LR onto the mother substrate MSUB.

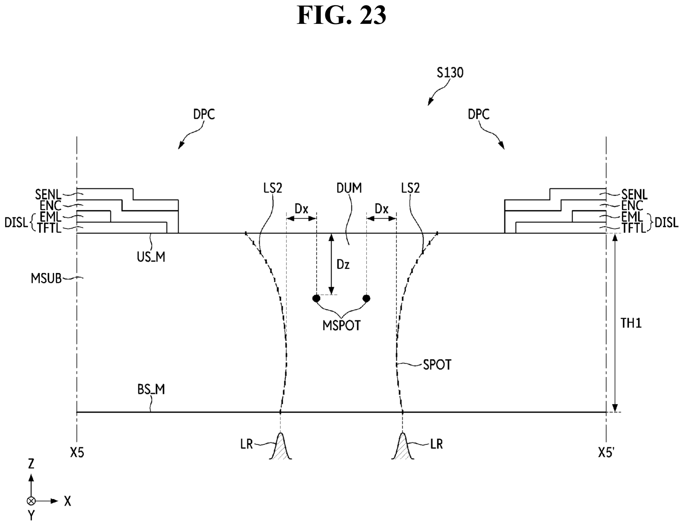

FIG. 21 is a perspective view showing operation S130 of FIG. 13. FIG. 22 is a cross-sectional view, taken along the line X4 - X4' in FIG. 21. FIG. 23 is a cross-sectional view taken along the line X5 - X5' in FIG. 21.

Referring to FIGS. 21 to 23, by irradiating a laser beam LR onto a second surface BS_M of the mother substrate MSUB, a plurality of first sketch lines LS1 arranged along the edges of a plurality of display cells DPC, and a plurality of second sketch lines LS2 for forming through holes TH in the respective display cells DPC, may be formed (S130 of FIG. 13).

The laser beam LR may be irradiated onto the second surface BS_M of the mother substrate MSUB. It should be understood, however, that the present disclosure is not limited thereto. The laser beam LR may be irradiated onto the first surface US_M of the mother substrate MSUB.

A first sketch line LS1 may be formed by irradiating a laser beam LR along the edge of each display cell DPC.

The shape of the first sketch line LS1 may depend on the shape of each display cell DPC when viewed from the top (e.g., in plan view). For example, if each display cell DPC has a rectangular shape when viewed from the top, the first sketch line LS1 may be formed in a rectangular shape when viewed from the top. It should be understood, however, that the shape of each display cell DPC is not limited to a rectangular shape, and may vary in a variety of ways.

The cross-sectional shape of the first sketch line LS1 may depend on the shape of the processing laser beam PLR of the laser beam LR described above. For example, the first sketch line LS1 may have a curved shape in cross-section. In cross-section cut along the third direction (z-axis direction), the first sketch line LS1 may have a curved shape convex toward the outside of the display cell DPC (or toward a dummy DUM).

The first sketch line LS1 may not overlap with the plurality of display cells DPC in the third direction (z-axis direction). For example, the first sketch line LS1 may be spaced apart from the plurality of display cells DPC in plan view. As the first sketch line LS1 and the plurality of display cells DPC do not overlap each other, the mother substrate MSUB and the dummy DUM described later may be separated (e.g., naturally or suitably separated) from each other after an etching process.

The second sketch line LS2 may be formed by irradiating a laser beam LR along the edge of a portion where a through hole TH is to be formed. The shape of the second sketch line LS2 may depend on the shape of the through hole TH when viewed from the top. For example, when the through hole TH has a circular shape when viewed from the top, the second sketch line LS2 may be formed in a circular shape when viewed from the top. It should be understood, however, that the shape of the through hole TH is not limited to a circular shape when viewed from the top and may vary in a variety of ways.

The cross-sectional shape of the second sketch line LS2 may depend on the shape of the processing laser beam PLR of the laser beam LR described above. For example, the second sketch line LS2 may have a curved shape in cross-section. In the cross-section cut along the third direction (z-axis direction), the second sketch line LS2 may have a curved shape convex toward the through hole TH (or the side where the through hole TH is to be located, or toward the dummy DUM).

The length of the first sketch line LS1 and the second sketch line LS2 in third direction (z-axis direction) may be equal to the first thickness TH1 (e.g., the thickness of the mother substrate MSUB) before etching. For example, the first thickness TH1 of the mother substrate MSUB, the length of the first sketch line LS1 in the third direction (z-axis direction), and the length of the second sketch line LS2 in the third direction (z-axis direction) may be, but is not limited to, approximately 500 µm.

Each of the first sketch line LS1 and the second sketch line LS2 may include a plurality of spots SPOT. The plurality of spots SPOT may be formed by a plurality of spot beams SPB of the processing laser beam PLR. The spots SPOT may include a physical hole formed by the processing laser beam PLR, and a region around the physical hole whose properties are changed by laser. Alternatively, the spot beams SPB may be regions whose properties are changed by the processing laser beam PLR without a physical hole.

This process of forming the first sketch line LS1 and the second sketch line LS2 by the laser beam LR may be referred to as a laser-sketch process.

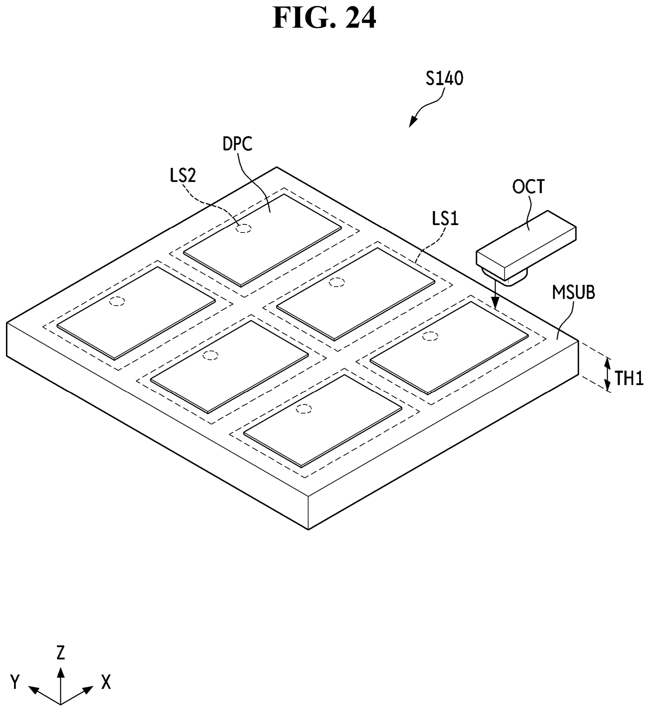

In the method S1 for fabricating a display device according to one or more embodiments, when the first sketch line LS1 and the second sketch line LS2 may be formed by the laser beam LR, a monitoring spot MSPOT may be formed together. The monitoring spot MSPOT may be a dummy sketch for monitoring deviations of the positions of the first sketch line LS1 and the second sketch line LS2 on the z-axis. The monitoring spot MSPOT will be described later with reference to FIG. 24, etc.

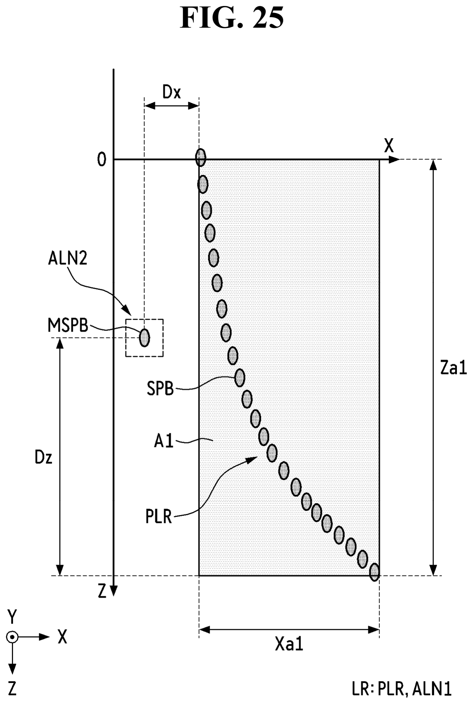

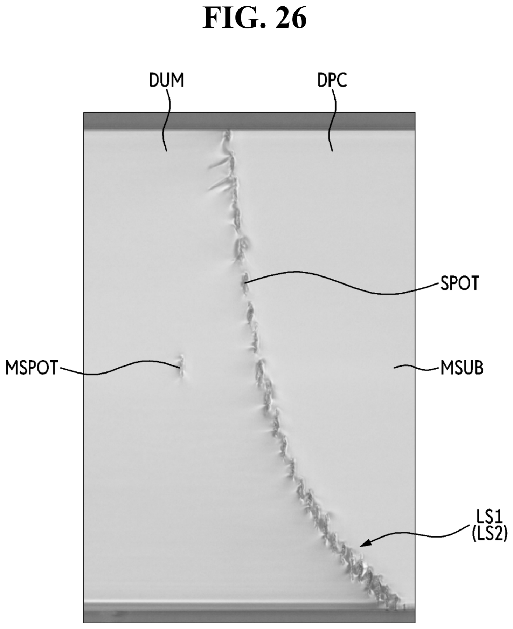

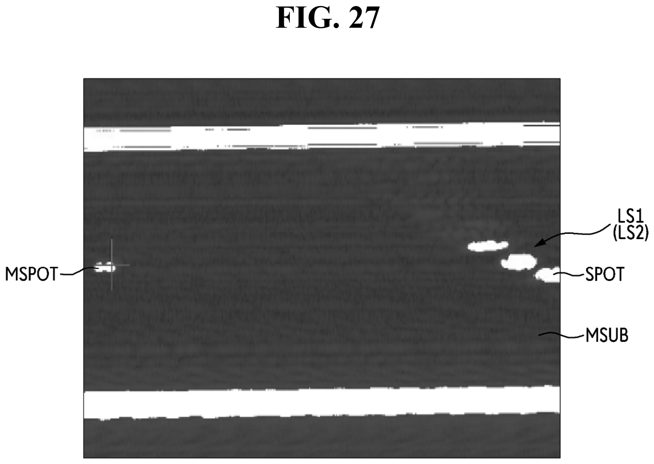

FIG. 24 is a perspective view for illustrating operation S140 of FIG. 13. FIG. 25 is a view schematically showing shapes of a laser beam and a second alignment key in the xz plane according to one or more embodiments. FIG. 26 is an image showing the shapes of a sketch line and a monitoring spot according to one or more embodiments. FIG. 27 is an image showing a cross-section of a mother substrate captured by a second inspection device according to one or more embodiments.

Referring to FIGS. 24 to 27 in conjunction with FIGS. 21 to 23, a plurality of first sketch lines LS1 and a plurality of second sketch lines LS2 may be checked using a second inspection device OCT (S140 of FIG. 13).

The inspection device OCT is an optical coherence tomography device that can non-invasively and non-destructively image internal structures (e.g., cross-sectional structures) by irradiating light on the surface of a target object (e.g., the mother board MSUB).

The inspection device OCT may scan the surface of the mother substrate MSUB on which sketch lines LS1 and LS2 are formed. The inspection device OCT may irradiate incident light onto the first surface US_M of the mother substrate MSUB, and may detect reflected light reflected off the mother substrate MSUB.

Some of the incident lights may be reflected off the first surface US_M of the mother substrate MSUB, and some others of the incident lights may transmit through the first surface US_M of the mother substrate MSUB. The incident light may be transmitted and reflected in a variety of ways at different points from the surface to the inside of the mother substrate MSUB.

For example, the transmission and reflection of the incident lights at the points where the sketch lines LS1 and LS2 are formed may be different from the transmission and reflection of the incident lights at the points where the sketch lines LS1 and LS2 are not formed.

Based on this, the inspection device OCT may analyze the optical characteristics of the reflected light reflected off the mother substrate MSUB to collect optical data on the shape of the sketch lines LS1 and LS2.

The laser beam LR may further include a second alignment key ALN2 in addition to the processing laser beam PLR and the first alignment key ALN1 described above.

The second alignment key ALN2 may be an alignment key for monitoring deviations of the z-axis positions of the first sketch line LS1 and the second sketch line LS2. The second alignment key ALN2 may include at least one monitoring spot beam MSPB.

The monitoring spot beam MSPB of the second alignment key ALN2 may be located within the positions of the plurality of spot beams SPB of the processing laser beam PLR in the third direction (z-axis direction). For example, the monitoring spot beam MSPB of the second alignment key ALN2 may be located at the same position in the third direction (z-axis direction) as a point of the first area A1 in the third direction (z-axis direction).

For example, as shown in FIG. 25, the distance Dz by which the monitoring spot beam MSPB is spaced apart from the end of the processing laser beam PLR in the third direction (z-axis direction) may be equal to or less than the length Za1 of the first area A1 in the third direction (z-axis direction). That is to say, as shown in FIG. 22 and FIG. 23, the distance Dz by which the monitoring spot MSPOT is spaced from the first surface US_M of the mother substrate MSUB in the third direction (z-axis direction) may be equal to or less than the first thickness TH1 of the mother substrate MSUB.

In some embodiments, the monitoring spot beam MSPB of the second alignment key ALN2 may be located on one side of the processing laser beam PLR in the first direction (x-axis direction) or in the second direction (y-axis direction). For example, as shown in FIG. 25, the monitoring spot beam MSPB of the second alignment key ALN2 may be located outside the first area A1 where the processing laser beam PLR is located.

For example, as shown in FIG. 25, the distance Dx by which the monitoring spot beam MSPB is spaced from the processing laser beam PLR in the first direction (x-axis direction) may be approximately 500 µm or less. That is to say, as shown in FIGS. 22 and 23, the distance Dx by which the monitoring spot MSPOT is spaced from the sketch lines LS1 and LS2 in the first direction (x-axis direction) may be approximately 500 µm or less.

As shown in FIG. 26, the monitoring spot MSPOT formed by the monitoring spot beam MSPB may be located on the side of the dummy DUM area, and not on the side adjacent to the display cell DPC. Accordingly, the monitoring spot MSPOT may not remain on the substrate SUB of the display device 10.

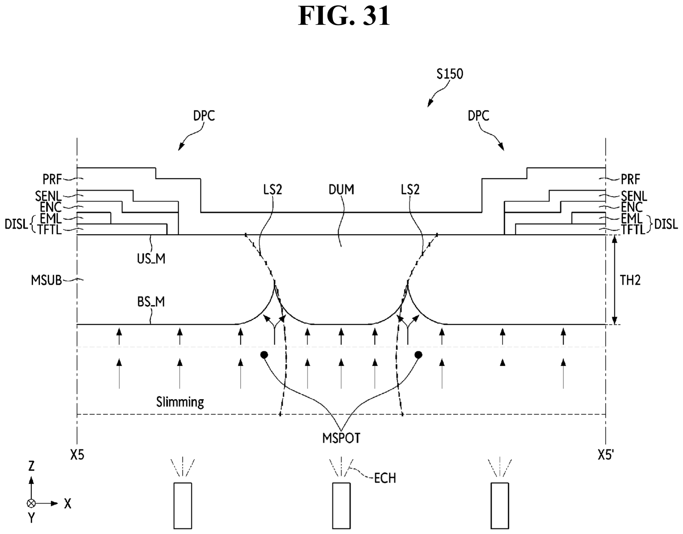

According to one or more other embodiments, as shown in FIG. 31 described below, the monitoring spot beam MSPB may be located on the side adjacent to the display cell DPC, not on the side adjacent to the dummy DUM area. In this instance, the monitoring spot beam MSPB may be located on the inner side of the first area A1 where the processing laser beam PLR is located. When the monitoring spot beam MSPB is located on the side adjacent to the display cell DPC, as described below, the monitoring spot MSPOT may be located on a portion of the mother substrate MSUB that is removed by etching. Accordingly, the monitoring spot MSPOT may not remain on the substrate SUB of the display device 10.

To check deviations on the z-axis of the laser beam LR, the second inspection device OCT may scan the surface of the mother substrate MSUB on which the monitoring spot MSPOT is formed. The inspection device OCT may irradiate incident light onto the first surface US_M of the mother substrate MSUB, and may detect reflected light reflected off the mother substrate MSUB. The second inspection device OCT may calculate the distance Dz by which the monitoring spot MSPOT is spaced from the first surface US_M of the mother substrate MSUB in the third direction (z-axis direction) based on the optical data of the reflected light.

As described above, as the shape of the laser beam LR is checked by the first inspection device VD, the relative positions of the processing laser beam PLR and the second alignment key ALN2 can be maintained substantially constant, so that it is possible to check deviations of the sketch lines LS1 and LS2 on the z-axis by checking only the z-axis deviations of the monitoring spot MSPOT.

According to one or more other embodiments, the second inspection device OCT may check the z-axis deviations of the sketch lines LS1 and LS2 based on the distance that the monitoring spot MSPOT is spaced from the second surface BS_M of the mother substrate MSUB in the third direction (z-axis direction).

Because the spot beams SPB of the processing laser beam PLR are relatively close, the spots SPOT of the sketch lines LS1 and LS2 are also relatively close, so that it may be difficult to check the z-axis deviations by the second inspection device OCT due to noise between adjacent spots SPOT. In contrast, the monitoring spot beam MSPB included in the second alignment key ALN2 is spaced separately from the processing laser beam PLR, and thus the noise of the monitoring spot MSPOT is small. Therefore, it may be suitable to check the z-axis deviations by the second inspection device OCT.

Therefore, in the method S1 for fabricating a display device according to one or more embodiments, it is possible to relatively quickly and accurately check whether the z-axis deviations of the laser beam LR based on the second alignment key ALN1.

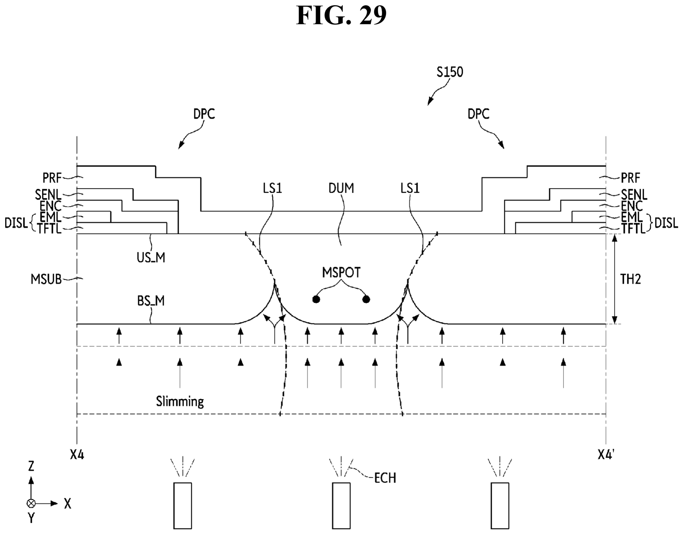

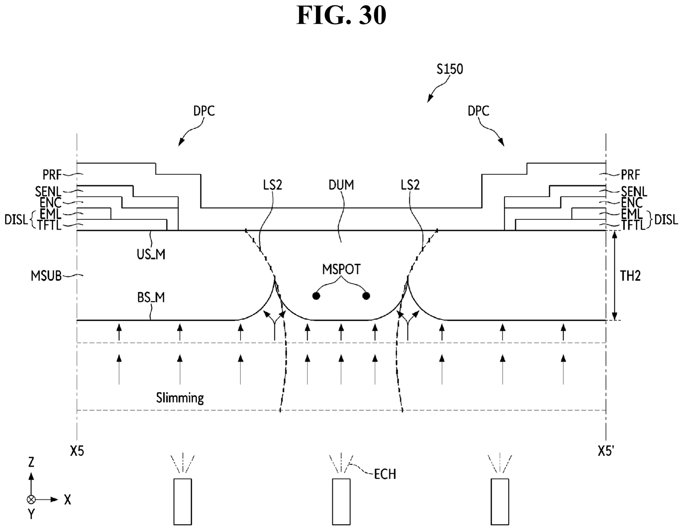

FIG. 28 is a perspective view for illustrating operation S150 of FIG. 13. FIG. 29 is a cross-sectional view showing an example, taken along the line X4 - X4' of FIG. 28. FIG. 30 is a cross-sectional view taken along the line X5 - X5' in FIG. 28. FIG. 31 is a cross-sectional view showing another example, taken along the line X5 - X5' of FIG. 28.

Referring to FIGS. 28 to 31, by spraying an etchant ECH onto a second surface BS_M of the mother substrate MSUB, the thickness of the mother substrate MSUB may be reduced, and the mother substrate MSUB may be cut along the first sketch line LS1 and the second sketch line LS2 (S150 of FIG. 13).

By spraying the etchant ECH onto the second surface BS_M of the mother substrate MSUB, the mother substrate MSUB can be thinned from the first thickness TH1 to the second thickness TH2. Because the mother substrate MSUB is etched without any mask, the entire second surface BS_M of the mother substrate MSUB may be etched uniformly (isotropic etching).

The first sketch line LS1 and the second sketch line LS2 may include physical holes formed by the laser beam LR, and regions around the physical holes whose properties are changed by the laser. Alternatively, the first sketch line LS1 and the second sketch line LS2 may be regions whose properties are changed by the laser beam LR without a physical hole. As a result, the etching rate in the regions adjacent to the first sketch line LS1 and the second sketch line LS2 may be higher than the etching rate in the other regions of the mother substrate MSUB where the first sketch line LS1 and the second sketch line LS2 are not irradiated.

As the etchant ECH permeates into the first sketch line LS1 and the second sketch line LS2, the mother substrate MSUB may be cut along the first sketch line LS1. That is to say, the dummy DUM may be cut from the mother substrate MSUB.

According to some embodiments, a protective film PRF may be attached on the display cells DPC before the etchant ECH is sprayed. The protective film PRF may be attached on the mother substrate MSUB and the display cells DPC. The protective film PRF may be an acid-resistant film for protecting the plurality of display cells DPC from the etchant ECH during the etching process.

According to some embodiments, as shown in FIGS. 29 and 30, the monitoring spot MSPOT may be located in the dummy DUM area. According to one or more other embodiments, as shown in FIG. 31, even if the monitoring spot MSPOT may be located on the side adjacent to the display cell DPC rather than the dummy DUM area, it may be located in the part of the mother substrate MSUB that is to be removed by etching. Accordingly, the monitoring spot MSPOT may be removed by the dummy DUM or by etching, so that it does not remain on the substrate SUB of the display device 10.

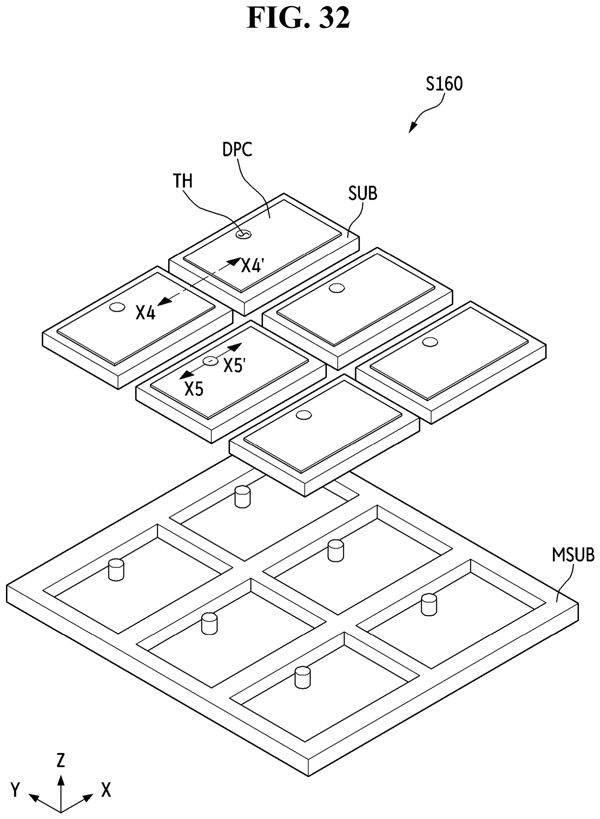

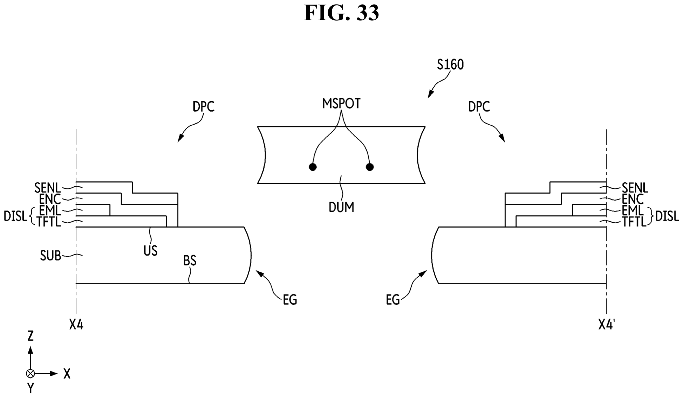

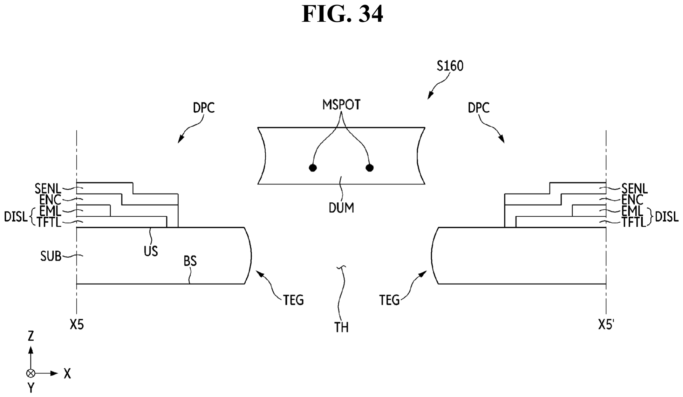

FIG. 32 is a perspective view for illustrating operation S160 of FIG. 13. FIG. 33 is a cross-sectional view taken along the line X4 - X4' in FIG. 21. FIG. 34 is a cross-sectional view taken along the line X5 - X5' of FIG. 21.

Referring to FIGS. 32 to 34, a plurality of display cells DPC may be separated from the mother substrate MSUB, and the dummy DUM may be separated from the plurality of display cells DPC, to form a through hole TH (S160 of FIG. 13).

Once the etching process has been completed, the protective film PRF may be removed. In some embodiments, the dummy DUM may be removed separately, but the present disclosure is not limited thereto. For example, the dummy DUM may be removed together with the protective film PRF.

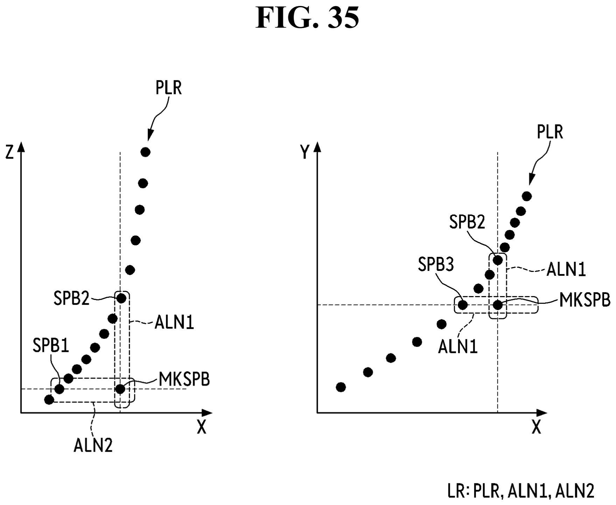

FIG. 35 is a view schematically showing the shapes of a laser beam and first and second alignment keys according to one or more other embodiments.

A method S1 for fabricating a display device according to the one or more embodiments corresponding to FIG. 35 is different from the method S1 for fabricating a display device described above with reference to FIG. 13 and the like in that a first alignment key ALN1 and a second alignment key ALN2 share a monitoring key spot beam MKSPB.

For example, a laser beam LR may include a monitoring key spot beam MKSPB. The monitoring key spot beam MKSPB may be included in the first alignment key ALN1 and the second alignment key ALN2. In other words, the first alignment key ALN1 and the second alignment key ALN2 may share the monitoring key spot beam MKSPB.

The monitoring key spot beam MKSPB may be located in the first area A1 where the processing laser beam PLR is positioned. For example, the monitoring key spot beam MKSPB may overlap with the processing laser beam PLR in each of the first direction (x-axis direction), the second direction (y-axis direction), and the third direction (z-axis direction). The processing laser beam PLR may include a first spot beam SPB1 having the same z-axis position (coordinate) as the monitoring key spot beam MKSPB, a second spot beam SPB2 having the same x-axis position (coordinate) as the monitoring key spot beam MKSPB, and a third spot beam SPB3 having the same y-axis position (coordinate) as the monitoring key spot beam MKSPB.

The first alignment key ALN1 may include the second spot beam SPB2, the third spot beam SPB3, and the monitoring key spot beam MKSPB. The second alignment key ALN2 may include the first spot beam SPB1 and the monitoring key spot beam MKSPB.

The first inspection device VD may use the first alignment key ALN1 to determine whether the second spot beam SPB2 and the monitoring key spot beam MKSPB are aligned on the x-axis, and whether the third spot beam SPB3 and the monitoring key spot beam MKSPB are aligned on the y-axis, thereby determining the alignment of the x-axis and y-axis.

The second inspection device OCT may determine the z-axis deviations by using the second alignment key ALN2 to determine whether the first spot beam SPB1 and the monitoring key spot beam MKSPB are aligned on the z-axis.

In the method S1 for fabricating a display device according to one or more embodiments, the monitoring key spot beam MKSPB is shared by the first alignment key ALN1 and the second alignment key ALN2, so that not only the x-axis and y-axis alignment but also z-axis deviations can be determined.

The display device 10 according to the above-described embodiments may be applied to a variety of electronic devices 1. The electronic device 1 may include the above-described display device 10, and may further include a module or device having additional functions in addition to the display device 10.

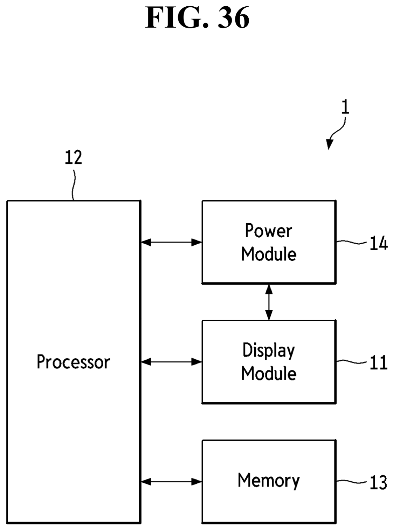

FIG. 36 is a block diagram of an electronic device according to one or more embodiments of the present disclosure.

Referring to FIG. 36, an electronic device 1 according to one or more embodiments of the present disclosure may include a display module 11, a processor 12, a memory 13, and a power module 14.

The processor 12 may include at least one of: a central processing unit (CPU), an application processor (AP), a graphic processing unit (GPU), a communication processor (CP), an image signal processor (ISP), or a controller.

The memory 13 may store data information required for the operation of the processor 12 or the display module 11. When the processor 12 executes an application stored in the memory 13, an image data signal and/or an input control signal may be transmitted to the display module 11. The display module 11 may process the received signal and output image information through a display screen.

The power module 14 may include a power supply module, such as a power adapter and a battery device, and a power conversion module that converts the power supplied by the power supply module to generate power required for the operation of the electronic device 1.

At least one of the elements of the electronic device 1 described above may be included in the display device 10 according to the embodiments described above. In addition, some of the individual modules functioning as a single module may be included in the display device 10 while some others may be provided separately from the display device 10. For example, the display device 10 may include the display module 11, and the processor 12, the memory 13, and/or the power module 14 may be provided as other devices inside the electronic device 1 than the display device 10.

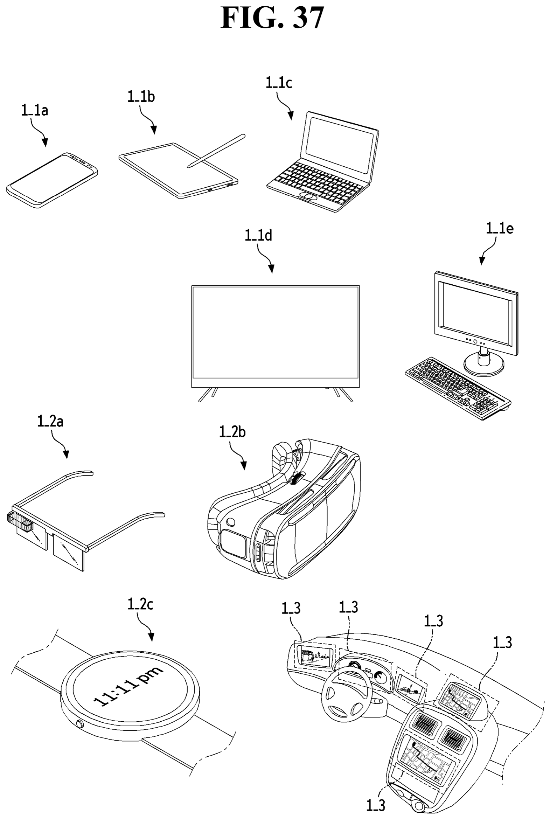

FIG. 37 is a view showing electronic devices according to a variety of embodiments of the present disclosure.

Referring to FIG. 37, a variety of electronic devices 1 employing the display devices 10 according to the embodiments may include not only image display electronic devices, such as a smart phone 1_1a, a tablet PC 1_1b, a laptop computer 1_1 c, a TV 1_1d and a desktop monitor 1_1e, but also wearable electronic devices including display modules, such as smart glasses 1_2a, a head-mounted display 1_2b and a smart watch 1_2c, and electronic devices for vehicles 1_3 including display modules, such as a center information display (CID) placed on the dashboard, the center fascia and the dashboard of a vehicle, and a room mirror display.

## Claims

1. A method for fabricating a display device (10), the method comprising:
forming display cells on a first surface of a mother substrate;
using a first inspection device to check alignment of a laser beam, which comprises a processing laser beam comprising spot beams arranged on a curve in a cross-section cut in a first direction that is a thickness direction of the mother substrate, and a first alignment key comprising key spot beams at a same height in the first direction, by focusing on the key spot beams;
irradiating the laser beam to form first sketch lines along edges of the display cells;
checking the first sketch lines using a second inspection device;
reducing a thickness of the mother substrate by spraying an etchant onto a second surface opposite to the first surface of the mother substrate; and
cutting the mother substrate along the first sketch lines.

2. The method of claim 1, wherein the key spot beams are in a first plane substantially perpendicular to the first direction.

3. The method of claim 1 or 2, wherein the key spot beams comprise:
a first key spot beam;
a second key spot beam aligned with the first key spot beam in a second direction substantially perpendicular to the first direction; and
a third key spot beam aligned with the second key spot beam in a third direction substantially perpendicular to the first direction and in a same plane as the second direction.

4. The method of any one of the preceding claims, wherein the laser beam comprises a first area where the spot beams are arranged, and a second area where the key spot beams are arranged and having a volume that is larger than a volume of the first area.

5. The method of claim 4, wherein the second area is above the first area; and/or wherein the second area does not overlap the first area in a horizontal direction substantially perpendicular to the first direction; and/or
wherein the laser beam further comprises a second alignment key comprising a monitoring spot beam overlapping the processing laser beam in a horizontal direction substantially perpendicular to the first direction.

6. The method of claim 5, wherein one of the first sketch lines comprises spots formed by the spot beams, and a monitoring spot formed by the monitoring spot beam.

7. The method of claim 6, wherein the monitoring spot is on a dummy between the display cells; and/or
wherein the monitoring spot is on a side of the processing laser beam that is adjacent to the display cells, and is removed by the etchant.

8. The method of claim 6, further comprising using the second inspection device to check deviations of the laser beam in the first direction based on a distance between the monitoring spot and the first surface in the first direction or a distance between the monitoring spot and the second surface in the first direction.

9. The method of any one of the preceding claims, wherein the first alignment key is above the processing laser beam in the first direction.

10. The method of any one of the preceding claims, wherein the first alignment key overlaps the processing laser beam in a horizontal direction substantially perpendicular to the first direction,
wherein the key spot beams comprise:
a first monitoring key spot beam on a straight line with a first spot beam among the spot beams in the first direction;
a second monitoring key spot beam on a straight line with a second spot beam among the spot beams in a second direction crossing the first direction; and
a third monitoring key spot beam on a straight line with a third spot beam among the spot beams in a third direction crossing the first direction and the second direction.

11. The method of any one of the preceding claims, further comprising forming second sketch lines for forming a through hole in the display cells by irradiating the laser beam.

12. The method of claim 11, further comprising inspecting the second sketch lines using the second inspection device;
reducing a thickness of the mother substrate by spraying the etchant onto the second surface of the mother substrate; and
cutting the mother substrate along the second sketch lines.

13. The method of any one of the preceding claims, further comprising separating the display cells from the mother substrate.

14. A display device (10) comprising:
a glass substrate comprising:
a first surface;
a second surface facing the first surface; and
a side surface between the first surface and the second surface, having a curved shape, and comprising a first layer adjacent to the second surface and comprising processing marks, and a second layer adjacent to the first surface and comprising processing marks, an average value of sizes of the processing marks of the first layer being less than an average value of sizes of the processing marks of the second layer;
an outermost structure on the first surface and adjacent to an edge of the side surface; and
a display area comprising emission areas further from the edge than the outermost structure on the first surface.

15. An electronic device comprising:
a display device (10) for displaying images fabricated by:
forming display cells on a first surface of a mother substrate;
using a first inspection device to check alignment of a laser beam, which comprises a processing laser beam comprising spot beams arranged on a curve in a cross-section cut in a first direction that is a thickness direction of the mother substrate, and a first alignment key comprising key spot beams at a same height in the first direction, by focusing on the key spot beams;
irradiating the laser beam to form first sketch lines along edges of the display cells;
checking the first sketch lines using a second inspection device;
reducing a thickness of the mother substrate by spraying an etchant onto a second surface opposite to the first surface of the mother substrate; and
cutting the mother substrate along the first sketch lines;
a processor (12) for providing an image driving signal to the display device (10); and
a power supply for supplying power to the display device (10) and the processor (12).
